# EUROPÄISCHE PATENTANMELDUNG

(11) **EP 3 863 054 A1**
(43) Veröffentlichungstag der Anmeldung: **11.08.2021**
(21) Anmeldenummer: 20155405.2
(22) Anmeldetag: 04.02.2020
(51) Int. Cl.: H01L 27/146

(54) **MULTIPLE SPEKTRALE DETEKTOREN MITTELS STRUKTURIERTER PEROWSKITE**

(71) Anmelder: Siemens Healthcare GmbH, 91052 Erlangen (DE)
(72) Erfinder: Deumel, Sarah, 91054 Erlangen-Sieglitzhof (DE); Tedde, Sandro Francesco, 91085 Weisendorf (DE); Hürdler, Judith Elisabeth, 90419 Nürnberg (DE)

(57) **Zusammenfassung**

Die Erfindung betrifft einen Detektor für elektromagnetische Strahlung, umfassend: eine erste Elektrodenschicht umfassend mindestens einen ersten Elektrodenpixel und einen zweiten Elektrodenpixel, eine zweite Elektrode, und eine erste Schicht umfassend mindestens einen ersten Perowskit, welche sich zwischen dem ersten Elektrodenpixel der ersten Elektrodenschicht und der zweiten Elektrode befindet, und eine zweite Schicht umfassend mindestens einen zweiten, vom ersten Perowskit verschiedenen, Perowskit, welche sich zwischen dem zweiten Elektrodenpixel der ersten Elektrodenschicht und der zweiten Elektrode befindet; einen Detektor für elektromagnetische Strahlung, umfassend: eine erste Elektrodenschicht umfassend mindestens einen ersten Elektrodenpixel und einen zweiten Elektrodenpixel, eine zweite Elektrode, und eine erste Schicht umfassend mindestens einen ersten Perowskit, welche sich zwischen dem ersten Elektrodenpixel der ersten Elektrodenschicht und der zweiten Elektrode befindet und zwischen dem zweiten Elektrodenpixel der ersten Elektrodenschicht und der zweiten Elektrode befindet, sowie Verfahren zu deren Herstellung.

## Beschreibung

Die Erfindung betrifft einen Detektor für elektromagnetische Strahlung, umfassend: eine erste Elektrodenschicht umfassend mindestens einen ersten Elektrodenpixel und einen zweiten Elektrodenpixel, eine zweite Elektrode, und eine erste Schicht umfassend mindestens einen ersten Perowskit, welche sich zwischen dem ersten Elektrodenpixel der ersten Elektrodenschicht und der zweiten Elektrode befindet, und eine zweite Schicht umfassend mindestens einen zweiten, vom ersten Perowskit verschiedenen, Perowskit, welche sich zwischen dem zweiten Elektrodenpixel der ersten Elektrodenschicht und der zweiten Elektrode befindet; einen Detektor für elektromagnetische Strahlung, umfassend: eine erste Elektrodenschicht umfassend mindestens einen ersten Elektrodenpixel und einen zweiten Elektrodenpixel, eine zweite Elektrode, und eine erste Schicht umfassend mindestens einen ersten Perowskit, welche sich zwischen dem ersten Elektrodenpixel der ersten Elektrodenschicht und der zweiten Elektrode befindet und zwischen dem zweiten Elektrodenpixel der ersten Elektrodenschicht und der zweiten Elektrode befindet, sowie Verfahren zu deren Herstellung.

Röntgendetektoren und Gammastrahlendetektoren/Gammadetektoren finden Verwendung in vielfältigen Bereichen. In herkömmlichen Röntgendetektoren wird die maximale und durchschnittliche Energie der Röntgenphotonen in Abhängigkeit des durchleuchteten Objektes gewählt. Beispielsweise wird in der industriellen Fertigung Röntgenstrahlung zum Testen von Materialien mittels Non-Destructive Testing (NDT) eingesetzt, wobei Röntgenstrahlung mit Energien von einigen Megaelektronenvolt (MeV) zum Einsatz kommen kann.

Eine wichtige Rolle spielen Röntgendetektoren auch in der medizinischen Diagnostik, wobei die verwendeten Energien der Röntgenstrahlung typischerweise in einem Bereich von etwa 20 bis 120 Kiloelektronenvolt (keV) liegen. Die untersuchten Substanzen weisen üblicherweise unterschiedliche Röntgenabsorptionsspektren auf. So unterscheidet sich beispielsweise die Absorptionsfähigkeit von Knochen, Weichteilen oder Gewebe in verschiedenen Energiebereichen deutlich voneinander. Um den Patienten keiner übermäßigen und unnötigen Strahlenbelastung auszusetzen, wird die Dosis der Röntgenstrahlung typischerweise derart ausgewählt, dass das Röntgenbild für Strukturen einer bestimmten Kategorie optimiert ist, etwa Knochen oder Weichteile. Die Energie der verwendeten Röntgenstrahlung wird somit in demjenigen Bereich gewählt, welche von der zu untersuchenden Struktur besonders stark absorbiert wird.

All diese Röntgendetektoren basieren auf der Integration der generieten Ladungsträger unabhängig von der Energie des Photons, das sie generiert hat. Dies ermöglicht, die Absorptionseigenschaften pixelweise zu bestimmen, gibt aber keine spektrale Information.

Vielfach ist es jedoch auch erforderlich, Informationen über die gesamte Zusammensetzung des zu bestrahlenden Objektes, insbesondere die spektrale Zusammensetzung, zu erhalten.

Spektrale Informationen in Röntgenbildern sind beispielsweise erhältlich über zählende Detektoren (z.B. Cadmiumtellurid, CdTe oder Cadmiumzinktellurid, CdZnTe basiert), die dedizierte und aufwändige (teure) Ansteuer- und Auslese-Elektronik aufweisen.

Eine Herstellung von spektral auflösenden Detektoren ist derzeit entsprechend aufwändig und teuer. Darüber hinaus sind diese nicht einfach in der Fläche skalierbar (z.B. bei CdTe).

Um beispielweise aus einem mittels Röntgen- oder Gammastrahlen aufgenommenen Bild von einem Patienten oder einem Objekt detaillierte Information über die Zusammensetzung der Materialien (bei Patienten z.B. Unterscheidung von Weichteilen und Knochen oder Erkennen bestimmter Biomarker) zu bekommen, gibt es weitere verschiedene Ansätze. Um beispielsweise sowohl Knochen als auch Gewebe zu erfassen, kann Röntgenstrahlung in verschiedenen Energiebereichen verwendet werden. Bei der sogenannten Dual-Röntgen-Absorptiometrie (Dual Energy X-ray Absorptiometry, DEXA) werden zwei unterschiedliche Aufnahmen mit verschiedenen Röntgenenergien gemacht. Die zwei Röntgenbilder, die mit verschiedenen Röntgenspektren aufgenommen wurden, können verglichen und ein Dual-Energy-Image berechnet werden.

Hierfür können entweder mit einer Röntgenröhre aufeinanderfolgend zwei Bilder aufgenommen werden, oder in einem Tomographen Bilder mit zwei verschiedenen Röntgenröhren mit unterschiedlichen Emissionsspektren aufgenommen werden. Ersteres ist abhängig von der Bewegung des Patienten zwischen den zwei aufgenommenen Bildern (Bewegungsartefakte), benötigt dafür aber keine zusätzliche Röntgenröhre. Mit Anspruch einer guten Bildauflösung ist die erste Variante normalerweise nicht in der Praxis verwendbar (Bewegungsartefakte). Ein anderer Ansatz besteht aus einem Detektor, der verschiedene Schichten aufweist. Jede Schicht ist auf eine andere Energie sensitiv. Hierfür wird oftmals eine Schichtung aus zwei oder mehr Szintillatoren mit einem Filter, beispielsweise in der Mitte, gewählt.

Beispielsweise ist es üblich, mehrere Detektoren zu stapeln, wobei beispielsweise der überliegende Detektor als Filter (Aufhärtung der Strahlung) für die unterliegenden dienen kann. Eine derartige Anordnung von mehreren Detektoren mit jeweils unterschiedlichen Energiebereichen ist etwa aus der US 8,488,736 B2 bekannt. Durch Kombination der Bilder kann verhindert werden, dass das Röntgenbild über- bzw. unterbelichtete Teile aufweist.

Durch das Stapeln von Detektoren ist es möglich, mit einer einzigen Röntgenquelle, welche Röntgenstrahlung in unterschiedlichen Energiebereichen aussendet, Bilder anhand der in den jeweiligen Energiebereichen durchgelassenen Strahlung zu erstellen. Hierzu wird jedoch eine Vielzahl von jeweils eigenständigen Detektoren benötigt.

Neuere Detektormaterialien bedienen sich der Eigenschaft des "Photon-Counting", mit der ebenfalls Informationen über die Energie der eintreffenden Photonen generiert werden können (z.B. D. Pacella, Energy-resolved X-ray detectors: the future of diagnostic imaging, 2015).

Gemeinsam haben die genannten Ansätze, dass sie in Anbetracht einer guten Bildauflösung teuer und aufwändig hergestellt werden müssen: Entweder muss eine zweite Röntgenröhre in dem Tomographen installiert werden, eine aufeinander abgestimmte Schichtung aus verschiedenen Szintillator- und Filtermaterialien in einem Detektor kombiniert werden, oder die Auflösung des Detektors muss so hoch sein, dass das Zählen von einzelnen Photonen möglich ist.

In einer Veröffentlichung von M. Sytnyk (M. Sytnyk, "The bright future of metal halide perovskites for X-ray detection", Appl. Phys. Lett. 115, 2019, DOI: 10.1063/1.5125999) wurde der Ansatz der Kombination mehrerer Szintillator-Schichten in einem Detektor aufgegriffen und in Form eines Gedankenexperiments weiter ausformuliert. M. Sytnyk et al. kombinieren vier verschiedene szintillierende Perowskit-Nanokristalle, die in verschiedenen Wellenlängen sichtbare Photonen emittieren und gleichzeitig als Filter für darunter liegende Schichten funktionieren. Die Absorption dieser Nanokristalle ist von der einfallenden Röntgenstrahlung abhängig. Die spektrale Information wird mittels einer Hyperspektralkamera (nicht auf Fläche skalierbar) wieder aufgelöst, oder mittels Einsatzes von Farbfiltern (nicht ohne massive Konversionsverluste). Ein Multi-Layer-Aufbau eines entsprechenden Detektors birgt zudem Schwierigkeiten in der Adhäsion zwischen den einzelnen Schichten und kann eventuell auch weitere Probleme bereiten, wie zum Beispiel bei der Anpassung der Kristallstruktur an die vorherige Schicht.

Entsprechend besteht ein Bedarf an multiplen spektralen Detektoren, welche einfach hergestellt werden können und sich durch gute Adhäsion und Stabilität auszeichnen.

Die Erfinder haben gefunden, dass durch eine Strukturierung der einzelnen Elektrodenpixel eines Detektors umfassend eine pixelierte Elektrode sowie entweder die Verwendung verschiedener Perowskite und/oder verschiedene Füllhöhen an Perowskit zur Detektion ein multispektraler Detektor mit guter Adhäsion der Detektionsschichten und guter Stabilität erhalten werden kann. Die vorliegen Erfindung bezieht sich entsprechend auf Detektoren, insbesondere direkte oder indirekte Röntgen- und/oder Gammastrahlendetektoren/Gammadetektoren, die als Absorbermaterial ein oder mehrere strukturierte Perowskite verwenden. Durch die Kombination von verschiedenen Perowskiten und/oder verschiedenen Höhen/Kristallstrukturen eines Perowskits können unterschiedliche Energien von Photonen detektiert werden, sodass mehr Informationen über die bestrahlten Objekte generiert werden können.

In einem ersten Aspekt betrifft die vorliegende Erfindung einen Detektor für elektromagnetische Strahlung, insbesondere einen Röntgen- und/oder Gammadetektor, umfassend:
- eine erste Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel,
- eine zweite Elektrode,
- eine erste Schicht umfassend mindestens einen ersten Perowskit, welche sich zwischen dem ersten Elektrodenpixel der ersten Elektrodenschicht und der zweiten Elektrode befindet, und
- eine zweite Schicht umfassend mindestens einen zweiten, vom ersten Perowskit verschiedenen, Perowskit, welche sich zwischen dem zweiten Elektrodenpixel der ersten Elektrodenschicht und der zweiten Elektrode befindet,
weiter umfassend eine Struktur, welche sich zumindest teilweise zwischen der ersten Elektrodenschicht und der zweiten Elektrode befindet und zwischen dem ersten Elektrodenpixel und dem zweiten Elektrodenpixel der ersten Elektrodenschicht derart angeordnet ist, dass sie zumindest teilweise auf dem Zwischenraum zwischen dem ersten Elektrodenpixel und dem zweiten Elektrodenpixel in Richtung der zweiten Elektrode von der ersten Elektrodenschicht weg angeordnet ist, wobei die erste Schicht umfassend mindestens einen ersten Perowskit zumindest teilweise in der Struktur in einem ersten Bereich derart eingebracht ist, dass sie sich über dem ersten Elektrodenpixel der ersten Elektrodenschicht befindet, und wobei die zweite Schicht umfassend mindestens einen zweiten Perowskit zumindest teilweise in der Struktur in einem zweiten Bereich derart eingebracht ist, dass sie sich über dem zweiten Elektrodenpixel der ersten Elektrodenschicht befindet, wobei die Struktur den ersten und zweiten Bereich trennt.

Ein zweiter Aspekt der vorliegenden Erfindung ist auf einen Detektor für elektromagnetische Strahlung, insbesondere einen Röntgen- und/oder Gammadetektor, gerichtet, umfassend:
- eine erste Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel,
- eine zweite Elektrode,
- eine erste Schicht umfassend mindestens einen ersten Perowskit, welche sich zwischen dem ersten Elektrodenpixel der ersten Elektrodenschicht und der zweiten Elektrode befindet und zwischen dem zweiten Elektrodenpixel der ersten Elektrodenschicht und der zweiten Elektrode befindet,
weiter umfassend eine Struktur, welche sich zumindest teilweise zwischen der ersten Elektrodenschicht und der zweiten Elektrode befindet und zwischen dem ersten Elektrodenpixel und dem zweiten Elektrodenpixel der ersten Elektrodenschicht derart angeordnet ist, dass sie zumindest teilweise auf dem Zwischenraum zwischen dem ersten Elektrodenpixel und dem zweiten Elektrodenpixel in Richtung der zweiten Elektrode von der ersten Elektrodenschicht weg angeordnet ist, wobei die erste Schicht umfassend mindestens einen ersten Perowskit zumindest teilweise in der Struktur derart eingebracht ist, dass sie sich über dem ersten Elektrodenpixel der ersten Elektrodenschicht in einem ersten Bereich und dem zweiten Elektrodenpixel der ersten Elektrodenschicht in einem zweiten Bereich befindet, wobei
sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet, wobei die Struktur den ersten und zweiten Bereich trennt.

In einem dritten Aspekt ist ein Verfahren zur Herstellung eines Detektors für elektromagnetische Strahlung, insbesondere eines Röntgen- und/oder Gammadetektors, offenbart, umfassend:
- Bereitstellen einer ersten Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel;
- Aufbringen einer Struktur zumindest teilweise auf den Zwischenraum der ersten Elektrodenschicht, wobei die Struktur derart aufgebracht wird, dass die Struktur auf dem Zwischenraum von der ersten Elektrodenschicht weg angeordnet ist, wobei die Struktur einen ersten Bereich über dem ersten Elektrodenpixel von einem zweiten Bereich über dem zweiten Elektrodenpixel trennt;
- Einbringen einer ersten Schicht umfassend mindestens einen ersten Perowskit und einer zweiten Schicht umfassend mindestens einen zweiten, vom ersten Perowskit verschiedenen, Perowskit in die Struktur, wobei die erste Schicht umfassend mindestens einen ersten Perowskit zumindest teilweise in der Struktur derart eingebracht ist, dass sie sich über dem ersten Elektrodenpixel der ersten Elektrodenschicht im ersten Bereich befindet, und wobei die zweite Schicht umfassend mindestens einen zweiten Perowskit zumindest teilweise in der Struktur derart eingebracht wird, dass sie sich über dem zweiten Elektrodenpixel der ersten Elektrodenschicht im zweiten Bereich befindet; und
- Aufbringen einer zweiten Elektrode auf die Struktur und/oder die erste Schicht umfassend mindestens einen ersten Perowskit und/oder die zweite Schicht umfassend mindestens einen zweiten Perowskit; oder
- Bereitstellen einer Struktur, wobei die Struktur mindestens einen Zwischenraum aufweist;
- Einbringen eines ersten Elektrodenpixels und eines zweiten Elektrodenpixels auf verschiedenen Seiten des Zwischenraums der Struktur, wobei der erste Elektrodenpixel und der zweite Elektrodenpixel die Struktur nicht füllen, und dadurch bilden einer ersten Elektrodenschicht, wobei die Struktur einen ersten Bereich über dem ersten Elektrodenpixel und einen zweiten Bereich über dem zweiten Elektrodenpixel trennt;
- Einbringen einer ersten Schicht umfassend mindestens einen ersten Perowskit und einer zweiten Schicht umfassend mindestens einen zweiten, vom ersten Perowskit verschiedenen, Perowskit in die Struktur, wobei die erste Schicht umfassend mindestens einen ersten Perowskit zumindest teilweise in der Struktur derart eingebracht ist, dass sie sich über dem ersten Elektrodenpixel der ersten Elektrodenschicht im ersten Bereich befindet, und wobei die zweite Schicht umfassend mindestens einen zweiten Perowskit zumindest teilweise in der Struktur derart eingebracht wird, dass sie sich über dem zweiten Elektrodenpixel der ersten Elektrodenschicht im zweiten Bereich befindet; und
- Aufbringen einer zweiten Elektrode auf die Struktur und/oder die erste Schicht umfassend mindestens einen ersten Perowskit und/oder die zweite Schicht umfassend mindestens einen zweiten Perowskit.

Ein vierter Aspekt der vorliegenden Erfindung betrifft ein Verfahren zur Herstellung eines Detektors für elektromagnetische Strahlung, insbesondere eines Röntgen- und/oder Gammadetektors, umfassend:
- Bereitstellen einer ersten Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel;
- Aufbringen einer Struktur zumindest teilweise auf den Zwischenraum der ersten Elektrodenschicht, wobei die Struktur derart aufgebracht wird, dass die Struktur auf dem Zwischenraum von der ersten Elektrodenschicht weg angeordnet ist, wobei die Struktur einen ersten Bereich über dem ersten Elektrodenpixel von einem zweiten Bereich über dem zweiten Elektrodenpixel trennt;
- Einbringen einer ersten Schicht umfassend mindestens einen ersten Perowskit zumindest teilweise in die Struktur derart, dass sie sich über dem ersten Elektrodenpixel der ersten Elektrodenschicht im ersten Bereich und dem zweiten Elektrodenpixel der ersten Elektrodenschicht im zweiten Bereich befindet, wobei
   sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet; und
- Aufbringen einer zweiten Elektrode auf die Struktur und/oder die erste Schicht umfassend mindestens einen ersten Perowskit; oder
- Bereitstellen einer Struktur, wobei die Struktur mindestens einen Zwischenraum aufweist;
- Einbringen eines ersten Elektrodenpixels und eines zweiten Elektrodenpixels auf verschiedenen Seiten des Zwischenraums der Struktur, wobei der erste Elektrodenpixel und der zweite Elektrodenpixel die Struktur nicht füllen, und dadurch bilden einer ersten Elektrodenschicht, wobei die Struktur einen ersten Bereich über dem ersten Elektrodenpixel und einen zweiten Bereich über dem zweiten Elektrodenpixel trennt;
- Einbringen einer ersten Schicht umfassend mindestens einen ersten Perowskit zumindest teilweise in die Struktur derart, dass sie sich über dem ersten Elektrodenpixel der ersten Elektrodenschicht im ersten Bereich und dem zweiten Elektrodenpixel der ersten Elektrodenschicht im zweiten Bereich befindet, wobei
   sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet; und - Aufbringen einer zweiten Elektrode auf die Struktur und/oder die erste Schicht umfassend mindestens einen ersten Perowskit.

Weitere Aspekte der vorliegenden Erfindung sind den abhängigen Ansprüchen und der detaillierten Beschreibung zu entnehmen.

Die beiliegenden Zeichnungen sollen Ausführungsformen der vorliegenden Erfindung veranschaulichen und ein weiteres Verständnis dieser vermitteln. Im Zusammenhang mit der Beschreibung dienen sie der Erklärung von Konzepten und Prinzipien der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander dargestellt. Gleiche, funktionsgleiche und gleich wirkende Elemente, Merkmale und Komponenten sind in den Figuren der Zeichnungen, sofern nichts anderes ausgeführt ist, jeweils mit denselben Bezugszeichen versehen.

Figur 1 zeigt schematisch einen beispielhaften erfindungsgemäßen Detektor des ersten Aspekts.

In Figuren 2 und 3 sind beispielhafte erfindungsgemäße Detektoren des zweiten Aspekts beispielhaft dargestellt.

Figuren 4 bis 13 zeigen schematisch verschiedene beispielhafte Strukturen, welche in erfindungsgemäßen Detektoren Anwendung finden können.

In Figuren 14 bis 18 ist schematisch ein beispielhaftes Verfahren gemäß dem dritten Aspekt gezeigt.

Figuren 19 bis 22 zeigen schematisch beispielhafte erste Schichten in erfindungsgemäßen Detektoren.

In Figuren 23 und 24 sind spektrale Eigenschaften unterschiedlicher Perowskite gegenübergestellt.

Figuren 25 und 26 zeigen Bilder von Detektoren von Beispielen der Erfindung.

In Figur 27 ist die Füllhöhe von Perowskit in einem Detektor mit Struktur dargestellt.

Figuren 28 bis 30 zeigen SEM-Aufnahmen von unbehandeltem und mit MA-Gas behandeltem, rekristallisierten Perowskit gezeigt.

So nicht anderweitig definiert, haben hierin verwendete technische und wissenschaftliche Ausdrücke dieselbe Bedeutung, wie sie von einem Fachmann auf dem Fachgebiet der Erfindung gemeinhin verstanden wird.

Mengenangaben im Rahmen der vorliegenden Erfindung beziehen sich auf Gew.%, soweit nicht anderweitig angegeben oder aus dem Kontext ersichtlich ist.

Ein erster Aspekt der vorliegenden Erfindung betrifft einen Detektor für elektromagnetische Strahlung, insbesondere einen Röntgen- und/oder Gammadetektor, umfassend:
- eine erste Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel,
- eine zweite Elektrode,
- eine erste Schicht umfassend mindestens einen ersten Perowskit, welche sich zwischen dem ersten Elektrodenpixel der ersten Elektrodenschicht und der zweiten Elektrode befindet, und
- eine zweite Schicht umfassend mindestens einen zweiten, vom ersten Perowskit verschiedenen, Perowskit, welche sich zwischen dem zweiten Elektrodenpixel der ersten Elektrodenschicht und der zweiten Elektrode befindet,
   weiter umfassend eine Struktur, welche sich zumindest teilweise zwischen der ersten Elektrodenschicht und der zweiten Elektrode befindet und zwischen dem ersten Elektrodenpixel und dem zweiten Elektrodenpixel der ersten Elektrodenschicht derart angeordnet ist, dass sie zumindest teilweise auf dem Zwischenraum zwischen dem ersten Elektrodenpixel und dem zweiten Elektrodenpixel in Richtung der zweiten Elektrode von der ersten Elektrodenschicht weg angeordnet ist, wobei die erste Schicht umfassend mindestens einen ersten Perowskit zumindest teilweise in der Struktur in einem ersten Bereich derart eingebracht ist, dass sie sich über dem ersten Elektrodenpixel der ersten Elektrodenschicht befindet, und wobei die zweite Schicht umfassend mindestens einen zweiten Perowskit zumindest teilweise in der Struktur in einem zweiten Bereich derart eingebracht ist, dass sie sich über dem zweiten Elektrodenpixel der ersten Elektrodenschicht befindet, wobei die Struktur den ersten und zweiten Bereich trennt.

Gemäß bestimmten Ausführungsformen des Detektors des ersten Aspekts ist der mindestens eine erste Perowskit in der ersten Schicht umfassend mindestens einen ersten Perowskit und/oder der mindestens eine zweite Perowskit in der zweiten Schicht zumindest teilweise rekristallisiert. Zudem kann sich gemäß bestimmten Ausführungsformen des Detektors des ersten Aspekts auch eine erste Füllhöhe der ersten Schicht umfassend mindestens einen ersten Perowskit über dem ersten Elektrodenpixel im ersten Bereich von einer zweiten Füllhöhe der zweiten Schicht über dem zweiten Elektrodenpixel im zweiten Bereich unterscheiden, wie im Detektor des zweiten Aspekts, also eine Mischform aus dem Detektor des ersten Aspekts und dem Detektor des zweiten Aspekts vorliegen. Entsprechend sind auch Ausführungen zu verschiedenen Füllhöhen im Zusammenhang mit dem Detektor des zweiten Aspekts auch sinngemäß auf verschiedene Ausführungsformen des Detektors des ersten Aspekts anwendbar.

Ein zweiter Aspekt der vorliegenden Erfindung betrifft einen Detektor für elektromagnetische Strahlung, insbesondere einen Röntgen- und/oder Gammadetektor, umfassend:
- eine erste Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel,
- eine zweite Elektrode,
- eine erste Schicht umfassend mindestens einen ersten Perowskit, welche sich zwischen dem ersten Elektrodenpixel der ersten Elektrodenschicht und der zweiten Elektrode befindet und zwischen dem zweiten Elektrodenpixel der ersten Elektrodenschicht und der zweiten Elektrode befindet,
weiter umfassend eine Struktur, welche sich zumindest teilweise zwischen der ersten Elektrodenschicht und der zweiten Elektrode befindet und zwischen dem ersten Elektrodenpixel und dem zweiten Elektrodenpixel der ersten Elektrodenschicht derart angeordnet ist, dass sie zumindest teilweise auf dem Zwischenraum zwischen dem ersten Elektrodenpixel und dem zweiten Elektrodenpixel in Richtung der zweiten Elektrode von der ersten Elektrodenschicht weg angeordnet ist, wobei die erste Schicht umfassend mindestens einen ersten Perowskit zumindest teilweise in der Struktur derart eingebracht ist, dass sie sich über dem ersten Elektrodenpixel der ersten Elektrodenschicht in einem ersten Bereich und dem zweiten Elektrodenpixel der ersten Elektrodenschicht in einem zweiten Bereich befindet, wobei
sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet, wobei die Struktur den ersten und zweiten Bereich trennt.

Gemäß bestimmten Ausführungsformen des Detektors des zweiten Aspekts ist der mindestens eine erste Perowskit in der ersten Schicht umfassend mindestens einen ersten Perowskit zumindest teilweise rekristallisiert.

Die folgende Beschreibung bezieht sich sowohl auf den Detektor des ersten Aspekts wie auch auf den Detektor des zweiten Aspekts, und beschriebene Ausführungsformen sind sowohl für den Detektor des ersten Aspekts wie auch den Detektor des zweiten Aspekts möglich, sofern nicht anderweitig angegeben oder aus dem Zusammenhang ersichtlich ist.

Gleiche Bauteile bzw. gleiche Materialen des Detektors des ersten und des zweiten Aspekts können in den verschiedenen Detektoren gleich oder verschieden sein.

Im Detektor des ersten Aspekts und dem Detektor des zweiten Aspekts ist die erste Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel nicht besonders beschränkt. Auch können mehr als zwei Elektrodenpixel in der ersten Elektrodenschicht angeordnet sein, und die erste Elektrodenschicht kann eine Vielzahl, also 2 oder mehr, beispielsweise 3, 4, 5, 6, 7, 8, 9, 10, 100, 1000 oder mehr, von Elektrodenpixeln bzw. Pixeln aufweisen, welche elektrisch kontaktiert werden können. Zwischen den einzelnen Elektrodenpixeln ist dann jeweils mindestens ein Zwischenraum vorhergesehen, sodass sich bei mehreren Elektrodenpixeln auch eine Vielzahl von Zwischenräumen ergeben kann. Gemäß bestimmten Ausführungsformen bilden mehrere X Elektrodenpixel als quasi Subpixel einen Pixel, wobei X größer als 1 ist, bevorzugt zwischen 2-4. Die X Elektrodenpixel können auch als Subpixel bezeichnet werden und ergeben dann gemeinsam ein spektral sensitiver Pixel. Anschaulich für die Pixel-Subpixel Konfiguration ist beispielsweise die RGB Pixel-Konfiguration eines LCD Fernseher (jedes Pixel hat RGB Subpixel dank Farbfiltern) .

Es ist weder die Pixelgröße noch das Material der jeweiligen Elektrodenpixel besonders beschränkt, und es können Elektrodenpixel verwendet werden, welche bereits bisher in Detektoren für elektromagnetische Strahlung, insbesondere Röntgen- und/oder Gammadetektoren, Anwendung gefunden haben. Als Elektrodenpixel kann beispielsweise ein Elektrodenpixel mit einem Pitch von 98 µm eines quadratischen Elektrodenpixels verwendet werden, was einen Elektrodenpixel definiert, wobei auch andere Pixelgrößen möglich sind. Das Material der Elektrodenpixel ist nicht besonders beschränkt und kann beispielsweise ein leitfähiges Metalloxid, ein leitfähiges Polymer, und/oder ein Metall umfassen, welches zur Detektion eines Elektrons und/oder Lochs, das durch einen Perowskit erzeugt wird, dient. So ein Substrat vorhanden ist, kann ein Substrat ein pixeliertes Substrat sein, auf dem sich die Elektrodenpixel der ersten Elektrodenschicht befinden.

Entsprechend der Zahl der Elektrodenpixel ist im Detektor des ersten Aspekts auch die Zahl der x Schichten umfassend mindestens einen x. Perowskit (mit x einer natürlichen ganzen Zahl ≥ 2) nicht besonders beschränkt, und der Detektor umfasst mindestens so viele Elektrodenpixel, wie verschiedene Schichten umfassend verschiedene Perowskite vorhanden sind. Hierbei ist nicht ausgeschlossen, dass in einem Detektor des ersten Aspekts auch eine Vielzahl an ersten Schichten umfassend mindestens einen ersten Perowskit über einer Vielzahl von ersten Elektrodenpixeln, eine Vielzahl an zweiten Schichten umfassend mindestens einen zweiten Perowskit über einer Vielzahl von zweiten Elektrodenpixeln, und ggf. weiteren entsprechenden Schichten und Elektrodenpixeln (also dritten, vierten, fünften, sechsten, siebten, achten, neunten, zehnten, etc. Schichten umfassend mindestens einen dritten, vierten, fünften, sechsten, siebten, achten, neunten, zehnten, etc. Perowskit über dritten, vierten, fünften, sechsten, siebten, achten, neunten, zehnten, etc. Elektrodenpixeln) vorkommt.

Analog ist im Detektor des zweiten Aspekts auch die Zahl der Elektrodenpixel und die Zahl der ersten Schichten umfassend mindestens einen ersten Perowskit mit unterschiedlicher Füllhöhe nicht besonders beschränkt, und der Detektor umfasst mindestens so viele Elektrodenpixel, wie erste Schichten umfassend verschiedene Füllhöhen vorhanden sind. Hierbei ist nicht ausgeschlossen, dass in einem Detektor des zweiten Aspekts auch eine Vielzahl an ersten Schichten umfassend mindestens einen ersten Perowskit über einer Vielzahl von ersten Elektrodenpixeln mit einer ersten Füllhöhe, eine Vielzahl an ersten Schichten umfassend mindestens einen ersten Perowskit über einer Vielzahl von zweiten Elektrodenpixeln mit einer zweiten Füllhöhe, und ggf. weiteren entsprechenden Schichten und Elektrodenpixeln (also Schichten umfassend mindestens einen ersten Perowskit mit verschiedenen dritten, vierten, fünften, sechsten, siebten, achten, neunten, zehnten, etc. Füllhöhen über entsprechenden dritten, vierten, fünften, sechsten, siebten, achten, neunten, zehnten, etc. Elektrodenpixeln) vorkommt.

Ebenfalls ist die Anordnung der Elektrodenpixel nicht besonders beschränkt, und diese können beispielsweise entsprechend einer aufzubringenden jeweiligen Schicht umfassend mindestens einen entsprechenden Perowskiten geeignet angeordnet sein.

So beispielsweise verschiedene Schichten umfassend verschiedene Perowskite im Detektor des ersten Aspekts zur Anwendung kommen, kann eine Anordnung der Elektrodenpixel derart erfolgen, dass jeweils Schichten mit verschiedenen Perowskiten aneinander angrenzen. So beispielsweise verschiedene Schichten umfassend mindestens vier verschiedene Perowskite vorhanden sind (also eine erste Schicht umfassend mindestens einen ersten Perowskit, eine zweite Schicht umfassend mindestens einen zweiten Perowskit, eine dritte Schicht umfassend mindestens einen dritten Perowskit und eine vierte Schicht umfassend mindestens einen vierten Perowskit), können diese wiederholt linear hintereinander in einer "Detektionsreihe" über jeweiligen Elektrodenpixeln angeordnet sein, oder bei einer Art zweidimensionaler Anordnung schachbrettartig in einem 2x2 Muster, wobei sich die jeweiligen Muster dann entsprechend in Detektoren mit einer Vielzahl von Elektrodenpixel wiederholen können und aneinander angrenzen können. Für unterschiedliche jeweilige Schichten umfassend mindestens einen entsprechenden Perowskit können sich analog auch verschiedene Anordnungen ergeben, wobei diese nicht in ihrer Form beschränkt sind. Neben linearen und schachbrettartigen Anordnungen von Elektrodenpixeln sind auch dreieckförmige, rhombische, mehreckige, etc. Anordnungen möglich, wobei die jeweilige Schicht umfassend den mindestens einen entsprechenden Perowskiten sich über einem Elektrodenpixel befindet. Es ist auch nicht ausgeschlossen, dass zwei Schichten umfassend einen gleichen Perowskiten im Detektor des ersten Aspekts aneinander angrenzen, so der Detektor mindestens eine erste Schicht umfassend mindestens einen ersten Perowskit und eine zweite Schicht umfassend mindestens einen zweiten, vom ersten Perowskit verschiedenen, Perowskit über verschiedenen Elektrodenpixeln aufweist.

Entsprechend den Ausführungen zur Anordnung der Elektrodenpixel im Detektor des ersten Aspekts kann analog auch eine Anordnung der Elektrodenpixel im Detektor des zweiten Aspekts erfolgen, also Schichten umfassend mindestens einen ersten Perowskit mit unterschiedlicher Füllhöhe über benachbarten und/oder nicht benachbarten Elektrodenpixeln, verschoben, versetzt, schachbrettartig, dreieckig, rhombisch, etc. angeordnet sein, wobei auch hier die Anzahl an verschiedenen Füllhöhen auf die Verteilung der Elektrodenpixel einen Einfluss haben kann.

Im Detektor des ersten Aspekts und im Detektor des zweiten Aspekts befindet sich in der ersten Elektrodenschicht mindestens ein Zwischenraum, wobei bei einer Mehrzahl an Elektrodenpixeln von mehr als 2 auch eine Mehrzahl an Zwischenräumen zwischen Elektrodenpixeln vorliegt, wobei die Elektrodenpixel in den Detektoren gegeneinander durch Zwischenräume getrennt sind. So eine Vielzahl von Elektrodenpixeln und Zwischenräumen zwischen den Elektrodenpixeln vorhanden sind, können diese beispielsweise eine Gitterstruktur bilden. Der Zwischenraum kann bzw. (bei einer Vielzahl davon) die Zwischenräume können in Detektoren des ersten und zweiten Aspekts ein nicht leitfähiges Material umfassen, welches nicht besonders beschränkt ist und auch beispielsweise ein Material eines Substrats sein kann, beispielsweise wenn Elektrodenpixel nach Materialentfernung in einem Substrats (z.B. durch Ätzen, etc.) und Einbringen der Elektrodenpixel in ein Substrat eingebracht werden, und/oder auch die Elektrodenpixel der ersten Elektrodenschicht anderweitig gegeneinander isolieren, beispielsweise durch ein Gas wie Luft, etc., beispielsweise wenn die Elektrodenpixel auf ein Substrat aufgebracht werden.

In erfindungsgemäßen Detektoren kann die erste Elektrodenschicht (wie auch die zweite Elektrode und/oder die erste Schicht und/oder die zweite Schicht, mit oder ohne unterschiedlicher Füllhöhe, sowie ggf. weitere Schichten und/oder das Substrat, etc.) eben und/oder gewölbt sein, sodass sich ebene oder auch gewölbte Detektoren ergeben können.

Darüber hinaus ist in den erfindungsgemäßen Detektoren auch die zweite Elektrode nicht besonders beschränkt. Gemäß bestimmten Ausführungsformen umfasst die zweite Elektrode ein leitfähiges Metalloxid, ein leitfähiges Polymer, und/oder ein Metall. Im erfindungsgemäßen Detektor können die erste und zweite Elektrode (bzw. die erste Elektrodenschicht und die zweite Elektrode) geeignet als Anode und/oder Kathode geschalten sein. Gemäß bestimmten Ausführungsformen ist die zweite Elektrode flächig ausgebildet. Gemäß bestimmten Ausführungsformen ist die zweite Elektrode zumindest teilweise durchlässig oder vollständig durchlässig für eine zu detektierende elektromagnetische Strahlung, welche nicht besonders beschränkt ist und beispielsweise Röntgen- (Wellenlänge ≥ 10 pm und < 10 nm) und/oder Gammastrahlung (Wellenlänge < 10 pm) sein kann. Beispielsweise kann die zweite Elektrode Indiumzinnoxid (ITO), Aluminium-Zink-Oxid (aluminium doped zinc oxide, AZO), Antimon-Zinn-Oxid (antimony tin oxide, ATO) und/oder Fluor-Zinn-Oxid (FTO) umfassen oder daraus bestehen.

Die Struktur ist ebenfalls nicht besonders beschränkt, sofern sie zumindest teilweise oder vollständig zwischen einzelnen Pixeln der ersten Elektrodenschicht angeordnet ist. Insbesondere ist die Struktur auch um die einzelnen Elektrodenpixel angeordnet, um Bereiche über den Elektrodenpixeln voneinander zu trennen, also beispielsweise einen ersten Bereich von einem zweiten Bereich, sowie ggf. diese von weiteren Bereichen, etwa einen dritten, vierten, fünften, sechsten, siebten, achten, neunten, zehnten, etc. Bereich, wobei auch diese Bereiche voneinander getrennt sind. Die Struktur dient in den erfindungsgemäßen Detektoren dazu, die einzelnen Elektrodenpixel und die Bereiche darüber voneinander zu trennen bzw. zu isolieren (stellt also eine Hilfsstruktur zur Separation verschiedener Bereiche dar, hat also eine Strukturierungfunktion), sodass die verschiedenen Elektrodenpixel Signale von den verschiedenen Perowskiten der ersten und zweiten Schichten im Detektor des ersten Aspekts bzw. Schichten mit unterschiedlichen Füllhöhen im Detektor des zweiten Aspekts detektieren können. Hierzu kann sich die Struktur auch teilweise auf und/oder über Elektrodenpixeln der ersten, pixelierten Elektrodenschicht befinden, sofern sie zumindest teilweise zwischen den Elektrodenpixeln der ersten Elektrodenschicht liegt, also beispielweise derart, dass sie in dem Zwischenraum bzw. Zwischenräumen bzw. in einer Gitterstruktur der ersten Elektrodenschicht (gebildet beispielsweise aus einem Nichtelektrodenmaterial der ersten Elektrodenschicht und/oder einem Gas wie Luft), direkt auf dem Zwischenraum bzw. Zwischenräumen bzw. der Gitterstruktur bzw. dem Material des Zwischenraums bzw. der Zwischenräume bzw. der Gitterstruktur zwischen Elektrodenpixeln, und/oder über dem Zwischenraum bzw. Zwischenräumen, also ebenfalls auf dem Material des Zwischenraums bzw. der Zwischenräume zwischen Elektrodenpixeln, beispielsweise der Gitterstruktur bzw. dessen Material, angeordnet ist. Hierzu ist die Struktur derart angeordnet, dass sie sich zumindest von der ersten Elektrodenschicht weg hin in Richtung der zweiten Elektrode erstreckt, also eine dreidimensionale Struktur bildet, welche sich zumindest zwischen der ersten Elektrodenschicht und der zweiten Elektrode befindet. Es ist hierbei nicht ausgeschlossen, dass sich auch Teile der Struktur innerhalb der ersten Elektrodenschicht befinden, beispielsweise in dem Zwischenraum bzw. den Zwischenräumen, um für eine bessere Verankerung der Struktur zu sorgen. Durch die Struktur, welche insbesondere als elektrisch isolierende Struktur aufgebracht ist, kann eine Vergrößerung der Ankeroberfläche für die erste Schicht und die zweite Schicht (sowie ggf. weitere Schichten umfassend mindestens einen entsprechenden Perowskit) im Detektor des ersten Aspekts wie auch die erste Schicht im Detektor des zweiten Aspekts auf der ersten Elektrodenschicht und ggf. somit auch auf einem Substrat ermöglichen.

Die Struktur befindet sich also gemäß bestimmten Ausführungsformen zumindest teilweise oder auch vollständig in einer Region, die durch den Zwischenraum bzw. die Zwischenräume bzw. die Gitterstruktur der ersten Elektrodenschicht zwischen einzelnen Elektrodenpixeln definiert ist, wobei die Struktur auch im Zwischenraum bzw. in den Zwischenräumen bzw. der Gitterstruktur liegen kann. Hierbei ist nicht ausgeschlossen, dass die Struktur auch teilweise auf und/oder über den Elektrodenpixeln der ersten Elektrodenschicht liegt. Die Struktur befindet sich derart zwischen den Elektrodenpixeln dass zumindest über dem Zwischenraum bzw. den Zwischenräumen der ersten Elektrodenschicht in Richtung der zweiten Elektrode eine 3D-Form gebildet bzw. ein dreidimensionaler Körper gebildet wird.

Zusätzlich zur Strukturierung ermöglicht die Struktur einen Herstellungsprozess, wo verschiedene Bereiche und Füllhöhen bzw. Schichtdicken von darin eingebrachten Schichten und somit ein Absorbermaterial der Schichten, also zumindest ein Perowskit, pixelweise definiert werden kann.

Gemäß bestimmten Ausführungsformen umgibt die Struktur den ersten Bereich und den zweiten Bereich sowie ggf. dritte, vierte, fünfte, sechste, siebte, achte, neune, zehnte, etc. Bereiche über dem jeweiligen Elektrodenpixel. So ein Elektrodenpixel am Rand eines Detektors liegt, kann die Struktur an diesem Rand auch durch ein Gehäuse des Detektors, etc., ersetzt sein, wobei das Gehäuse nicht besonders beschränkt ist und insbesondere nicht elektrisch leitend ist. Gemäß bestimmten Ausführungsformen ist jedoch jeder Bereich über jedem Elektrodenpixel von der Struktur umgeben. Die erste Schicht umfassend mindestens einen ersten Perowskit sowie die zweite Schicht umfassend mindestens einen zweiten Perowskit sowie ggf. weitere Schichten umfassend entsprechende weitere Perowskite, wie oben beispielhaft für bis zu zehn Schichten angegeben, werden im Detektor des ersten Aspekts gemäß bestimmten Ausführungsformen in die Struktur über den jeweiligen Elektrodenpixeln derart eingefüllt, dass sie durch den jeweiligen Elektrodenpixel und die Struktur begrenzt sind und die Füllhöhe der jeweiligen Schicht bevorzugt nicht über die Höhe der Struktur hinausgeht. Entsprechend wird im Detektor des zweiten Aspekts die erste Schicht umfassend mindestens einen ersten Perowskit in die Struktur über den jeweiligen ersten, zweiten, sowie ggf. dritten, vierten, fünften, sechsten, siebten, achten, neunten, zehnten, etc. Elektrodenpixeln derart eingefüllt, dass sie durch den jeweiligen Elektrodenpixel und die Struktur begrenzt sind und die Füllhöhe der jeweiligen Schicht bevorzugt nicht über die Höhe der Struktur hinausgeht.

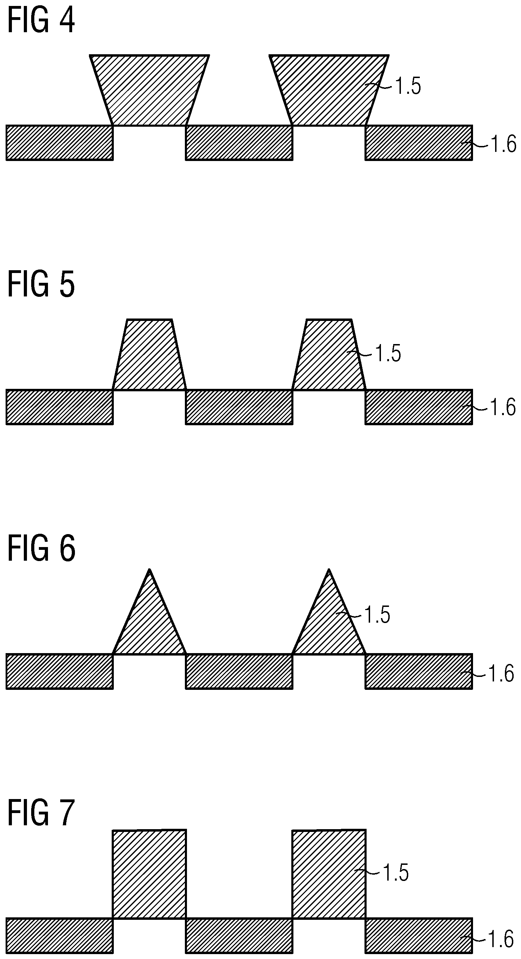

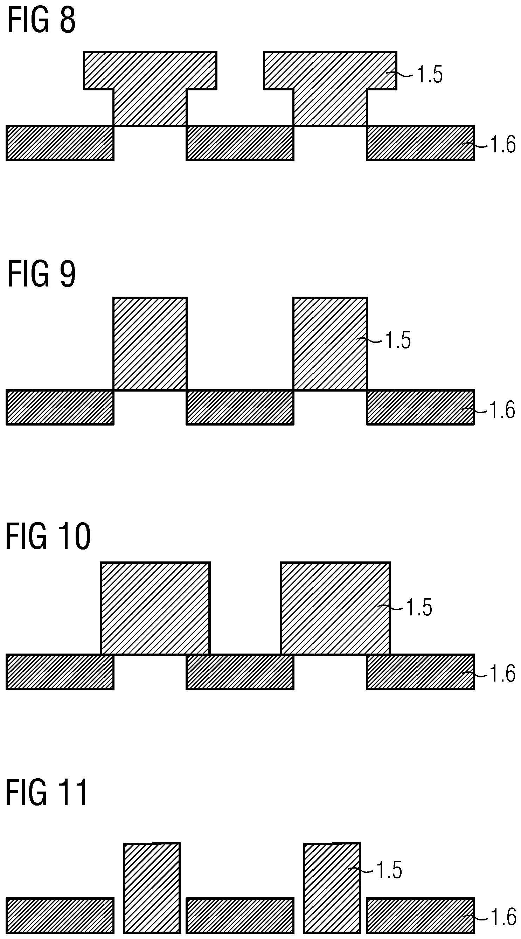

Die Form eines solchen Körpers der Struktur ist nicht besonders beschränkt. Beispielhafte Formen für die Struktur sind schematisch in Form zweidimensionaler Schnitte in Figuren 4 bis 13 gezeigt. Aus diesen Figuren wird auch deutlich, wie die Struktur 1.5 zumindest teilweise zwischen den Elektrodenpixeln 1.6 angeordnet ist. In Figuren 4 und 5 sind beispielsweise Strukturen gezeigt, welche sich zur (nicht gezeigten, darüber befindlichen) zweiten Elektrode verbreitern bzw. verjüngen. Solche Formen sind beispielsweise durch die Verwendung unterschiedlicher Photolacke (negative bzw. positive Photolacke) bei der Herstellung erhältlich. Auch die in Figuren 6 bis 8 gezeigten Formen sind beispielsweise durch Verwendung verschiedener Photolacke erhältlich, und/oder durch andere, nachfolgend dargelegte Verfahren. Die in Figur 8 gezeigte Form kann z.B. mittels eines Lift-off Resists (LOR) hergestellt werden.

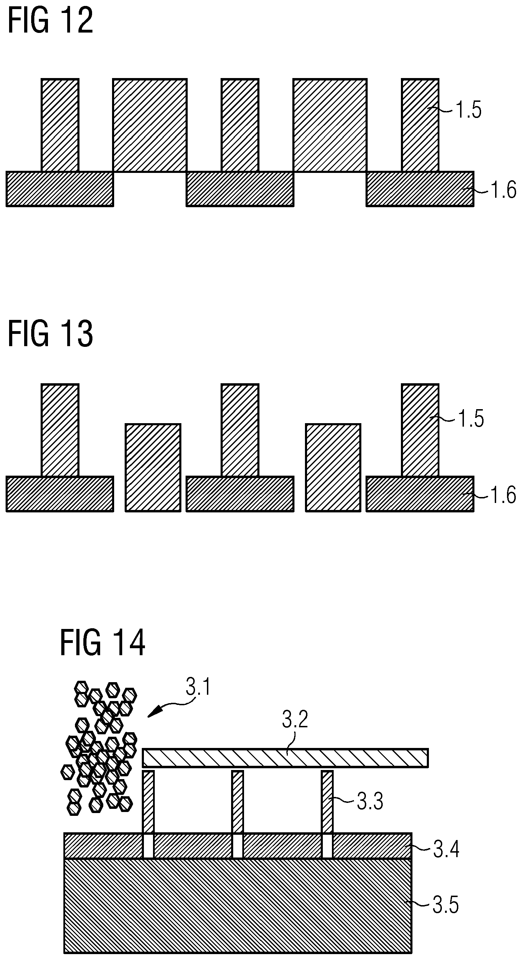

Neben verschiedenen Formen können auch die Abmessungen der Struktur 1.5 variieren, wie in Figuren 9 bis 11 zu sehen ist: Ein Beispiel wäre, dass die Strukturen 1.5 genau zwischen die Elektrodenpixel 1.6 passen (Figur 9); in einem anderen Beispiel ist die Struktur 1.5 breiter als der Abstand zwischen den Elektrodenpixeln 1.6, also der Zwischenraum (Figur 10); alternativ kann die Struktur 1.5 auch schmaler als der Abstand der Elektrodenpixel 1.6 sein, wobei hier dann auch die Struktur 1.5 in den Zwischenraum bzw. die Zwischenräume eingebracht sein kann (was auch in den anderen Figuren nicht ausgeschlossen ist; Figur 11). Weiterhin können auch Teile der Struktur 1.5 noch zusätzlich oberhalb der aktiven Fläche der Elektrodenpixel 1.6 ergänzt werden, wie in den Figuren 12 und 13 schematisch gezeigt wird. Hierdurch kann die Haftung der ersten Schicht und zweiten Schicht im Detektor des ersten Aspekts bzw. der ersten Schicht im Detektor des zweiten Aspekts weiter verstärkt werden, jedoch kann die Detektion durch die Verringerung der zur Detektion verfügbaren aktiven Fläche der Elektrodenpixel 1.6 ebenfalls verringert sein.

Die verschiedenen Formen der Struktur sind daneben auch auf andere Weise erhältlich, beispielsweise durch selektives Ätzen und/oder Laserabtragung eines Substrats mit anschließender Einbringung der Elektrodenpixel in geätzte und/oder abgetragene Bereiche des Substrats, wobei hierbei dann das Material des Zwischenraums bzw. der Zwischenräume der ersten Elektrodenschicht und der Struktur dem Material des Substrats entsprechen kann, und/oder durch 3D-Drucken. In solchen Fällen sind als Material der Struktur beispielsweise verschiedene Polymere, Keramiken, etc. möglich. Entsprechende Verfahren zum selektiven Ätzen sind beispielsweise aus J.D. Zahn et al., "A direct plasma etch approach to high aspect ratio polymer micromachining with applications in biomems and CMOSmems", Technical Digest. MEMS 2002 IEEE International Conference. Fifteenth IEEE International Conference on Micro Electro Mechanical Systems, DOI: 10.1109/MEMSYS.2002.984223 bekannt. Ein beispielhaftes Verfahren zum Laserabtragen ist beispielsweise in V.N. Tokarev et al., "High-aspect-ratio microdrilling of polymers with UV laser ablation: experiment with analytical model", Appl. Phys. A, 2002, DOI: 10.1007/s00339-002-1511-8 beschrieben. Ein Verfahren zum 3D-Drucken ist beispielsweise aus A. Kain et al., "High aspect ratio- and 3D- printing of freestanding sophisticated structures", Procedie Chemistry 1, 2009, 750-753, DOI: 10.1016/j.proche.2009.07.187 bekannt.

Auch die Maße der Struktur sind nicht besonders beschränkt. Bevorzugt ist jedoch eine Struktur, welche von der Oberfläche der ersten, pixelierten Elektrodenschicht eine Höhe von 0,5 bis 5000 µm, bevorzugt 0,8 bis 4000 µm, weiter bevorzugt 1 bis 3000 µm, noch weiter bevorzugt 10 bis 2000 µm, z.B. 20 bis 1800 µm oder 30 bis 1700 µm, insbesondere 50 bis 1500 µm aufweist. Für die Struktur sind auch bei mehreren Elektrodenpixeln in einzelnen Regionen der Trennung von verschiedenen Bereichen über verschiedenen Elektrodenpixeln verschiedene Höhen (und/oder ggf. auch Breiten) möglich, beispielsweise wenn in einem Detektor des zweiten Aspekts Elektrodenpixel auf unterschiedlichen Höhen und/oder mit unterschiedlichen Dicken angeordnet sind, um unterschiedliche Füllhöhen der ersten Schicht umfassend mindestens einen ersten Perowskit zu ermöglichen. Auch ist eine Struktur mit einen hohen Aspektverhältnis (Verhältnis Höhe zu Breite) bevorzugt, insbesondere wenn sich die Struktur als "Gitter" und/oder "Wand" von der Oberfläche der ersten, pixelierten Elektrodenschicht weg erstreckt (wobei sie den ersten und zweiten Bereich trennt), wobei hier dann eine Breite der Wand und/oder der Querstreben des Gitters beispielsweise 0,5 bis 80 µm, bevorzugt 1 bis 50 µm, weiter bevorzugt 2 bis 35 µm, noch weiter bevorzugt 3 bis 25 µm, noch weiter bevorzugt 4 bis 15 µm, insbesondere 5 bis 10 µm, betragen kann, wobei die Breite beispielsweise direkt auf der Oberfläche der ersten, pixelierten Elektrodenschicht gemessen werden kann, insbesondere bei sich verjüngenden oder verbreiternden Strukturen oder anderweitig unregelmäßig geformten Strukturen. Das Aspektverhältnis kann hierbei abhängig sein vom Anwendungsgebiet (z.B. Mammographie (MAMMO), Radiologie (RAD), Fluoroskopie (FLUORO), Non-Destructive Testing (NDT)), der Härte der zu detektierenden elektromagnetischen Strahlung, der Absorptionseigenschaften des Perowskits, der diese Strahlung direkt oder indirekt (bei Anwesenheit einer Schicht umfassend mindestens einen Szintillator), etc.

Es ist auch nicht ausgeschlossen, dass die Elektrodenpixel in die Struktur bei der Herstellung eingefüllt werden, also erst nach der Struktur erzeugt werden. Hier können ggf. auch höhere Aspektverhältnisse erzielt werden. So die Struktur auch in den Zwischenräumen liegt, befinden sich die Elektrodenpixel quasi in der Struktur, sodass hier die erste Elektrodenschicht auch von Teilen der Struktur gebildet sein kann, im Bereich des Zwischenraums bzw. der Zwischenräume der ersten Elektrodenschicht (hier wäre dann die erste Elektrodenschicht beispielsweise als eine Schicht gleicher Höhe zur Höhe der Elektrodenpixel bzw. des dünnsten Elektrodenpixels zu verstehen, die gedanklich aus dem Detektor herausgenommen wird, wobei dann sich zwischen den Elektrodenpixeln das Material der Struktur befindet und somit den Zwischenraum bzw. die Zwischenräume zwischen den Elektrodenpixeln ausfüllt). Der Zwischenraum hat bzw. die Zwischenräume haben hierbei insbesondere dann, wie auch sonst in der ersten Elektrodenschicht, eine Höhe, welche der Höhe der Elektrodenpixel (auch als Pixelelektroden bezeichnet) entspricht. Die Elektrodenpixel können hierbei einen Füllungsfaktor der Struktur (also in den nicht durch das Material der Struktur gefüllten Bereichen der Struktur, beispielsweise in einer Gitterstruktur als Struktur) von beispielsweise bis zu 90% aufweisen, bevorzugt jedoch <50%, bevorzugt <10%, mehr bevorzugt <2%.

Es ist beispielsweise eine Größe bzw. ein Pitch eines Elektrodenpixels von 150 µm oder mehr, eine Breite der Struktur von 50 µm und weniger und/oder einer Höhe der Struktur von bis zu 1250 µm möglich.

Das Material der Struktur ist ebenfalls nicht besonders beschränkt, ist bevorzugt jedoch elektrisch isolierend, um einen Kurzschluss zwischen einzelnen Elektrodenpixeln zu vermeiden. Das Material der Struktur kann hierbei auch von der Herstellung der Struktur selbst abhängen. Wie oben beschrieben kann das Material der Struktur auch dem Material des Zwischenraums bzw. der Zwischenräume und ggf. auch eines Substrats entsprechen, kann aber auch verschieden sein, beispielsweise bei einer Auftragung von Material wie beim 3D-Drucken oder der Auftragung von Lacken.

So ist eine beispielhafte Herstellung der Struktur durch die Auftragung von Lacken, beispielsweise Photolacken, möglich, welche durch Formen und/oder Masken geeignet strukturiert und ggf. auch mehrmals aufgetragen werden können. Die Lacke, beispielsweise Photolacke, sind nicht besonders beschränkt. Durch eine geeignete Auswahl der Lacke, beispielsweise Photolacke, kann auch eine Haftung der ersten Schicht und zweiten Schicht und insbesondere des mindestens einen ersten Perowskits und des mindestens einen zweiten Perowskits im Detektor des ersten Aspekt bzw. der ersten Schicht und insbesondere des mindestens einen ersten Perowskits im Detektor des zweiten Aspekts an der Struktur beeinflusst werden. Dies schließt auch ein Benetzungsverhalten des Materials der ersten Schicht und der zweiten Schicht bzw. der ersten Schicht und insbesondere des mindestens einen ersten Perowskits und mindestens einen zweiten Perowskits bzw. des mindestens einen ersten Perowskits ein, falls diese bzw. dieser bei einem erfindungsgemäßen Verfahren zur Rekristallisation zumindest teilweise verflüssigt wird. Entsprechendes gilt auch für andere Materialien bei anderen Herstellungsverfahren, wie oben erwähnt.

Die verschiedenen Photolacke sind nicht besonders beschränkt und können beispielsweise sowohl positive wie negative oder andere strukturierbare Materialien sein. Beispiele für positive Photolacke bzw. Photoresists sind z.B. AZ 10XT, AZ 12XT, AZ 40XT, AZ 4533, AZ 4562, AZ 9245, AZ 9260, AS IPS 6050, AZ P4110, AZ P4260, AZ P4903 und PL 177 der Firma Microchemicals GmbH, und Beispiele für negative Photolacke z.B. AZ 125nXT, AZ 125 nXT (115CPS), AZ 15nXT (450CPS), AZ nLof 2020, AZ nLof 2035, AZ nLof 2070 und AZ nLof 5510 der Firma Microchemicals GmbH. Weitere Beispiele für Photolacke sowie Verfahren zu deren Strukturierung sind in B. Loechel, "Thick-layer resists for surface micromachining", J. Micromech. Microeng. 10, 2000, 108-115 genannt. Als weiteres Beispiel für einen Photolack ist SU-8 zu nennen, beispielsweise in A. del Campo und C. Greiner, "SU-8: a photoresist for high-aspect-ratio and 3D submicron lithography", J. Microchem. Microeng. 17, 2007, R81-R95 beschrieben.

Die erste Schicht umfassend mindestens einen ersten Perowskit und die zweite Schicht umfassend mindestens einen zweiten Perowskit, der vom ersten Perowskit verschieden ist, im Detektor des ersten Aspekts sind ebenfalls nicht besonders beschränkt bzw. die erste Schicht umfassend mindestens einen ersten Perowskit im Detektor des zweiten Aspekts ist ebenfalls nicht besonders beschränkt. Die Menge an erstem Perowskit in der ersten Schicht und die Menge an zweitem Perowskit in der zweiten Schicht bzw. von weiteren Perowskiten im Detektor des ersten Aspekts in weiteren Schichten, welche von den anderen Perowskiten verschieden sind, ist auch nicht besonders beschränkt. Gemäß bestimmten Ausführungsformen umfasst die erste Schicht den mindestens einen ersten Perowskit in einer Menge von ≥ 30 Gew.%, ≥ 50 Gew.%, oder ≥ 70 Gew.%, bezogen auf die erste Schicht, oder besteht im Wesentlichen aus dem ersten Perowskit (z.B. ≥ 90 Gew.%, ≥ 95 Gew.%, oder ≥ 99 Gew.%, bezogen auf die erste Schicht); oder besteht sogar aus dem mindestens einen ersten Perowskit, umfasst die zweite Schicht den mindestens einen zweiten Perowskit in einer Menge von ≥ 30 Gew.%, ≥ 50 Gew.%, oder ≥ 70 Gew.%, bezogen auf die erste Schicht, oder besteht im Wesentlichen aus dem zweiten Perowskit (z.B. ≥ 90 Gew.%, ≥ 95 Gew.%, oder ≥ 99 Gew.%, bezogen auf die zweite Schicht); oder besteht sogar aus dem mindestens einen zweiten Perowskit, etc.

Die Füllhöhe der ersten und der zweiten Schicht und etwaiger weiterer Schichten umfassend mindestens einen entsprechenden Perowskiten im Detektor des ersten Aspekts ist nicht besonders beschränkt und kann beispielsweise der Höhe der Struktur entsprechen, also beispielweise eine Höhe von 0,5 bis 5000 µm, bevorzugt 0,8 bis 4000 µm, weiter bevorzugt 1 bis 3000 µm, noch weiter bevorzugt 10 bis 2000 µm, z.B. 20 bis 1800 µm oder 30 bis 1700 µm, insbesondere 50 bis 1500 µm aufweisen, kann aber auch geringer oder größer sein, im Detektor des ersten Aspekts bevorzugt jedoch gleich oder geringer, um eine Kontaktierung der Schichten umfassend verschiedene Perowskite zu vermeiden. Im Detektor des zweiten Aspekts unterscheiden sich die Füllhöhen der ersten Schicht umfassend den mindestens einen ersten Perowskit in unterschiedlichen Bereichen, also im ersten, zweiten und etwaigen weiteren Bereichen, wobei die Füllhöhe in einem (z.B. ersten) Bereich beispielsweise der Höhe der Struktur entsprechen kann, also beispielweise eine Höhe von 0,5 bis 5000 µm, bevorzugt 0,8 bis 4000 µm, weiter bevorzugt 1 bis 3000 µm, noch weiter bevorzugt 10 bis 2000 µm, z.B. 20 bis 1800 µm oder 30 bis 1700 µm, insbesondere 50 bis 1500 µm aufweisen kann, oder geringer oder größer sein kann, und in weiteren Bereichen (z.B. einem zweiten, dritten, vierten, etc. Bereich) niedriger als diese Höhe sein, beispielsweise um 10, 20, 30, 40, 50, 60, 70, 80, 90% oder mehr.

In der ersten Schicht ist der mindestens eine erste Perowskit nicht besonders beschränkt, und es können ein Perowskit oder eine Mehrzahl von Perowskiten, beispielsweise 2, 3, 4, 5 oder mehr Perowskite umfasst sein. Gemäß bestimmten Ausführungsformen umfasst die erste Schicht einen Perowskit. Im Detektor des zweiten Aspekts ist zudem in der zweiten Schicht der mindestens eine zweite Perowskit nicht besonders beschränkt, und es können ein Perowskit oder eine Mehrzahl von Perowskiten, beispielsweise 2, 3, 4, 5 oder mehr Perowskite umfasst sein, wobei sich mindestens einer von einem Perowskiten der ersten Schicht unterscheidet. Gemäß bestimmten Ausführungsformen umfasst die zweite Schicht einen Perowskit. Entsprechendes gilt auch, wenn darüber hinaus mehrere Schichten umfassend weitere Perowskite vorgesehen sind.

Der erste Perowskit, der zweite Perowskit, etc. sind nicht besonders beschränkt. Beispielsweise können sowohl organisch-anorganische als auch rein anorganische Perowskite mit einer ABX₃-Struktur, mit einem oder mehreren Kationen (A⁺), einem oder mehr B⁺-Kationen und einem oder mehr Halogeniden X⁻ Anwendung finden, welche nicht besonders beschränkt sind. Beispiele geeigneter Perowskite als erster Perowskit, zweiter Perowskit, etc. im Detektor des ersten Aspekts bzw. als erster Perowskit im Detektor des zweiten Aspekts sind gemäß bestimmten Ausführungsformen MAPbI₃ (CH₃NH₃PbI₃), MAPbBr₃ (CH₃NH₃PbBr₃), FAPbI₃(HC(NH₂)₂PbI₃), MAPbICl₂(CH₃NH₃PbICl₂), FAPbBr₃(HC(NH₂)₂PbBr₃), EAPbI₃(CH₃CH₂NH₃PbI₃), PAPbI₃ (CH₃CH₂CH₂NH₃PbI₃), BA₂PbI₄((CH₃CH₂CH₂CH₂NH₃)₂PbI₄), PMA₂PbI₄ ((C₆H₅CH₂NH₃)₂PbI₄), PEA₂PbI₄((C₆H₅CH₂CH₂NH₃)₂PbI₄), EAPbBr₃ (CH₃CH₂NH₃PbBr₃), PAPbBr₃(CH₃CH₂CH₂NH₃PbBr₃); Mischhalogenide derselben; anorganisch-organische Perowskite mit einer Mischung von A-Kationen mit Halogeniden X (X =C l, I, und/oder Br), wie beispielsweise MAFAPbX₃ (MA = CH₃NH₃, FA = HC(NH₂)₂), MAGAPbX₃ (GA = Guanidinium), BAPAPbX₃ (BA = CH₃CH₂CH₂CH₂NH₃, PA = CH₃CH₂CH₂NH₃); organisch halogenierte Mischungen, bei denen die Halogene teilweise durch andere Halogene ersetzt sind (z.B. mit Halogeniden der Formel I₃-xClx oder Br3-xClx, etc., z.B. MAPbI₃-xClx oder CH₃NH₃PbBr₃-xClx); organische und/oder organisch-anorganische Perowskite, bei denen Pb zumindest teilweise oder sogar vollständig durch Sn, Cu, Ni, Bi, Co, Fe, Mn, Cr, Cd, Ge und/oder Yb substituiert ist, und/oder Mischungen davon; anorganische Perowskite und Mischungen davon, beispielsweise CsPbX₃, wobei X = Cl, Br, und/oder I, sowie Mischungen davon, Cs₃Bi₂X₉, wobei X = Cl, Br, und/oder I, sowie Mischungen davon, Cs₃Sb₂X, wobei X = Cl, Br, und/oder I, sowie Mischungen davon, Cs₂AgBiX₆, wobei X = Cl, Br, und/oder I, sowie Mischungen davon, Rb₃Bi₂X₉, wobei X = Cl, Br, und/oder I, sowie Mischungen davon, Rb₃Sb₂X₉, wobei X = Cl, Br, und/oder I, sowie Mischungen davon, CsSnI₃; etc., sowie Mischungen der Perowskite.

Durch die erste Schicht (Detektor des ersten und zweiten Aspekts), zweite Schicht und ggf. weitere Schichten (Detektor des ersten Aspekts) kann, in Verbindung mit der Struktur, zudem eine verbesserte Haftung weiterer Schichten an der ersten Elektrodenschicht erzielt werden.

Die Einbringung der ersten Schicht und zweiten Schicht und etwaiger weiterer Schichten in die Struktur im Detektor des ersten Aspekts bzw. der ersten Schicht im Detektor des zweiten Aspekts ist nicht besonders beschränkt, und sie können bzw. kann derart eingebracht sein, dass sie die Struktur nur teilweise füllen bzw. füllt, sie können bzw. kann derart eingebracht sein, dass sie die Struktur genau füllen bzw. füllt, also mit einer Oberkante oder einem obersten Punkt der Struktur abschließt, oder sie können bzw. kann derart eingebracht sein, dass sie über die Struktur hinausgehen bzw. hinausgeht, also diese füllen bzw. füllt und zudem teilweise oder vollständig bedecken bzw. bedeckt, wobei letzteres nicht bevorzugt ist, insbesondere für den Detektor des ersten Aspekts. Auch kann die Form der Einbringung, also die Füllung bei nicht vollständiger Füllung, vom Material der Struktur abhängig sein, wie oben beschrieben.

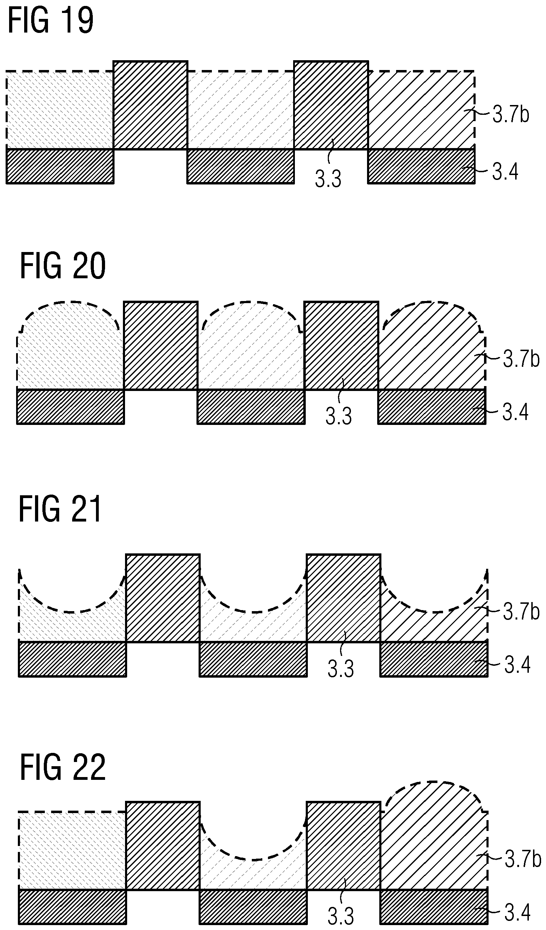

Verschiedene Beispiele für solche verschiedenen Füllungen sind in Figuren 19 bis 22 gezeigt. Gezeigt sind hierbei Elektrodenpixel 3.4 mit der Struktur 3.3 sowie der ersten Schicht 3.7b (bzw. weiteren, verschiedenen Schichten, die hier nicht bezeichnet sind und hier dem Detektor des ersten Aspekts entsprechen), welche beispielsweise einen rekristallisierten ersten Perowskit umfasst, wie nachstehend erläutert. Eine Variante ist, dass die erste Schicht 3.7b mit ebener Oberkante (gerade Ebene unterhalb der Höhe der Struktur) in die Struktur 3.3 eingefüllt ist, wie in Figur 19 gezeigt. Zusätzlich können die Schichten inklusive der ersten Schicht 3.7b eine positive Wölbung (Figur 20) besitzen, oder eine negative, wie in Figur 21 dargestellt, oder Mischungen von ebenen Oberkanten, positiven Wölbungen und/oder negativen Wölbungen, wie in Figur 22 zu sehen ist. Dies hängt beispielsweise vom Benetzungsverhalten (hydrophob, hydrophil) der Struktur und/oder der ersten Elektrodenschicht, beispielsweise der Elektrodenpixel, ab. Andere Formen sind auch denkbar.

Gemäß bestimmten Ausführungsformen ist der mindestens eine erste Perowskit in der ersten Schicht umfassend mindestens einen ersten Perowskit zumindest teilweise rekristallisiert und insbesondere rekristallisiert. Hierdurch kann die erste Schicht besser mit der Struktur verbunden werden. Im Detektor des ersten Aspekts ist zudem der mindestens eine zweite Perowskit in der zweiten Schicht umfassend mindestens eine zweiten Perowskit - sowie ggf. weitere Perowskite in weiteren Schichten - zumindest teilweise rekristallisiert und insbesondere rekristallisiert. Hierdurch kann die zweite Schicht und können ggf. weitere Schichten besser mit der Struktur verbunden werden.

Das Rekristallisieren ist hierbei nicht besonders beschränkt. Insbesondere unterscheidet sich der rekristallisierte erste Perowskit von einem nicht rekristallisierten ersten Perowskit, der rekristallisierte zweite Perowskit von einem nicht rekristallisierten zweiten Perowskit, etc., da sich die Kristallstruktur beim Rekristallisieren ändert. Entsprechend kann eine entsprechende erste, zweite und ggf. weitere Schicht mit zumindest teilweise oder vollständig rekristallisiertem Perowskit (hier auch rekristallisierte Schicht genannt) leicht von einer anderen Schicht mit demselben Perowskit, in der dieser nicht rekristallisiert ist, unterschieden werden, weil die Schichten eine unterschiedliche Morphologie aufweisen, die einfach mit Röntgenelektronenmikroskopie (REM) oder Transmissionselektronenmikroskopie (TEM) anhand von Bilder zu erfassen ist. Auch Röntgenbeugungs-(XRD) Spektren der Schichten weisen Unterschiede auf.

Eine Rekristallisation kann auf verschiedene Art und Weise erfolgen, beispielsweise durch Schmelzen unter Verwendung von Methylamin-Gas, insbesondere bei Perowskiten, welche Methylammonium-Ionen enthalten, durch Druck und/oder Temperatur, wobei die Verfahren auf den verwendeten Perowskit angepasst werden können. Beispielsweise umfasst der erste, zweite, etc. Perowskit Alkylammoniumionen, insbesondere mit 1 - 4 C-Atomen, weiter bevorzugt Methylammoniumionen, und die Behandlung zur Herstellung einer ersten, zweiten, ggf. weiteren Schicht erfolgt mit einem Gas umfassend Methylamin, insbesondere mit Methylamin-Gas.

Die Behandlung von Perowskiten, die Methylammonium-Ionen enthalten, mittels Methylamin (MA)-Gas ist bereits im Jahr 2017 von Li et al. publiziert worden (Li, C., S. Pang, H. Xu und G. Cui. Methylamine gas based synthesis and healing process toward upscaling of perovskite solar cells: Progress and perspective. Solar RRL, 1(9), 1700076 (2017).). In ihrem Paper beschreiben sie die Verflüssigung der zuvor festen Perowskitschicht nach der Einwirkung von MA-Gas und die anschließende Rekristallisierung mit einer veränderten Morphologie, sobald das MA-Gas nicht mehr in der Atmosphäre enthalten ist. Das Patent EP 3304611 B1 bedient sich diesem Phänomen, um einen Perowskit aus Präkursoren (u.a. einem Metallhalogenid), die auf zwei verschiedenen Oberflächen aufgetragen wurden, herzustellen. In der CN 10209088003 A ist ein Prozess beschrieben, bei dem ein einkistallines Perowskit-Pulver auf eine mesoporöse Schicht, wie zum Beispiel Titanoxid, aufgetragen und mittels MA-Gas verflüssigt wird. Als flüssige Metaphase dringt das Perowskit in die Poren ein und rekristallisiert dort.

Insbesondere ist Behandlung mit MA-Gas bevorzugt, da es technisch einfach handhabbar ist und nur geringe Mengen an MA-Gas (z.B. in einer Kammer mit Unterdruck mit einem Druck des MA-Gases von 10⁻⁶ mbar bis 10 bar, z.B. in einer Kammer mit einem Volumen von 1 L (beispielsweise 0,25 g MA-Gas bei 200 mbar Druck)) erforderlich sind, was Kosten spart.

Die erste, zweite und ggf. weitere Schicht kann hierbei auch schichtweise mehrfach aufgebracht und rekristallisiert werden. Die erste, zweite und ggf. weitere Schicht umfassend mindestens einen ersten, zweiten und ggf. weiteren verflüssigten und rekristallisierten Perowskit kann hier insbesondere als Haftvermittler zwischen der ersten Elektrodenschicht oder einer optional anderen, darauf aufgebrachten Schicht wie einer Elektronenleiter- oder Lochleiterschicht und einer ggf. weiteren Schicht umfassend mindestens einen Szintillator dienen.

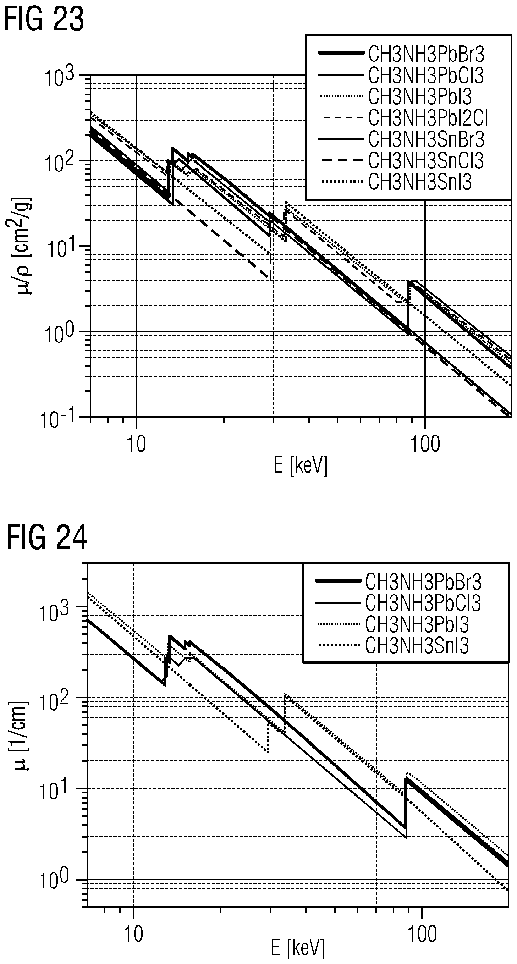

Im Detektor des ersten Aspekts werden zumindest ein erster Perowskit und zumindest ein zweiter Perowskit sowie ggf. weitere Perowskite verwendet. Die Kombination solcher Perowskite, die in die verschiedenen abgetrennten Bereiche mit den jeweiligen Schichten eingefüllt sind, kann abhängig sein von deren Absorptionskoeffizienten in Abhängigkeit der Wellenlänge bzw. Energie der einstrahlenden elektromagnetischen Strahlung. Figur 23 zeigt hier Beispiele für verschiedene Massenschwächungskoeffizienten µ/ρ von verschiedenen Perowskiten mit MA⁺ in Abhängigkeit der Photonenenergie E von Röntgenstrahlung. In Figur 24 sind darüber hinaus verschiedene Absorptionskoeffizienten µ von verschiedenen Perowskiten mit MA⁺ in Abhängigkeit der Photonenenergie E von Röntgenstrahlung gezeigt. In beiden Spektren sind die Absorptionskanten deutlich zu erkennen. Aus beiden Spektren wird deutlich, dass hier durch verschiedene Perowskite verschiedene Strahlung unterschiedlich detektiert werden kann, sodass hier eine spektrale Auflösung eines zu untersuchenden Materials möglich ist.

Im Detektor des zweiten Aspekts kann die spektrale Auflösung über die verschiedenen Füllhöhen erzielt werden. Elektrodenpixel (auch im Sinne von Subpixeln) mit der niedrigsten Füllhöhe ermöglichen nur das vollständige Erfassen von niederenergetischer elektromagnetischer Strahlung. Mit steigender Füllhöhe steigt der absorbierte Anteil der hochenergetischen Photonen. Die Korrelation der Signale der Elektrodenpixel ermöglicht eine spektrale Information.

Gemäß bestimmten Ausführungsformen umfassen ein Detektor des ersten Aspekts oder ein Detektor des zweiten Aspekts weiter eine Schicht umfassend mindestens einen Szintillator, welche sich zumindest zwischen der Struktur und der zweiten Elektrode befindet. Hierdurch ist eine indirekte Detektion von Strahlung in den Schichten umfassend Perowskit möglich, wie oben beschrieben. So mehrere Schichten umfassend verschiedene Szintillatoren aufgebracht werden, ist auch hier eine weitere spektrale Auflösung möglich.

Die Schicht umfassend mindestens einen Szintillator ist hierbei nicht besonders beschränkt. Gemäß bestimmten Ausführungsformen weist sie eine Dicke (in Richtung zwischen der ersten, pixelierten Elektrodenschicht und der zweiten Elektrode) von 5 bis 5000 µm, bevorzugt 10 bis 3000 µm, weiter bevorzugt 50 bis 2000 µm, noch weiter bevorzugt 100 bis 1500 µm auf. Die dritte Schicht kann als separate Schicht hergestellt werden, beispielsweise als separat hergestellte Szintillatorschicht, und kann sowohl freistehend als auch nicht freistehend sein, also beispielsweise auch bei der Herstellung in Kontakt mit der zweiten Elektrode oder einer optionalen elektronenleitenden oder lochleitenden Schicht sein, z.B. in Kontakt mit einer ITO oder FTO-Elektrode, wobei die zweite Elektrode auch beispielweise auf einer transparenten Oberflächenschicht wie einem Glas sein kann.

Gemäß bestimmten Ausführungsformen ist die Schicht umfassend mindestens einen Szintillator in Kontakt mit der ersten Schicht und zweiten Schicht und ggf. weiteren Schichten (Detektor des ersten Aspekts) bzw. der ersten Schicht (Detektor des zweiten Aspekts) und/oder der Struktur.

In Ausführungsformen mit Schicht umfassend mindestens einen Szintillator dient diese insbesondere als Detektionsschicht für hochenergetische Strahlung, beispielsweise Röntgen- und/oder Gammastrahlung, und die Schicht bzw. Schichten umfassend mindestens einen Perowskit dient bzw. dienen der indirekten Detektion durch die Konversion von Photonen, die in der Schicht umfassend mindestens einen Szintillator erzeugt werden.

Der Szintillator der Schicht umfassend mindestens einen Szintillator ist nicht besonders beschränkt. Beispielsweise sind CsI:Tl, mit Thallium dotiertes Cäsiumiodid, mit Terbium dotiertes Gadoliniumoxysulfid, Bariumfluorid (BaF₂), Bismutgermanat (BGO), Berylliumfluorid (BeF₃), Quantendots, szintillierende Perowskit-Nanokristalle, etc., als Szintillator geeignet.

Gemäß bestimmten Ausführungsformen umfassen ein Detektor des ersten Aspekts oder ein Detektor des zweiten Aspekts weiter eine elektronenleitende und/oder eine lochleitende Schicht, welche sich zwischen der ersten Elektrodenschicht und der zweiten Elektrode befindet. Es können auch mehrere elektronenleitende und/oder lochleitende Schichten im Detektor umfasst sein.

Die elektronenleitende und/oder lochleitende Schicht ist hierbei nicht besonders beschränkt, und es können nur eine elektronenleitende Schicht, nur eine lochleitende Schicht oder eine elektronen- und eine lochleitende Schicht in erfindungsgemäßen Detektoren vorhanden sein. Eine elektronenleitende und/oder lochleitende Schicht stellt hierbei eine Zwischenschicht dar, welche auch als Interlayer bezeichnet wird. Ein Interlayer ist entsprechend eine Zwischenschicht, die entweder als Elektrontransport- (bzw. Loch-blockierende (HBL)) Schicht, also als elektronenleitende Schicht, oder als Lochtransport-(bzw. Elektronen-blockierende (EBL)) Schicht, also als lochleitende Schicht funktioniert.

Die Materialien für solche elektronenleitende und/oder lochleitende Schichten sind nicht besonders beschränkt, und es können solche zur Anwendung kommen, welche in üblichen elektronenleitenden und/oder lochleitenden Schichten zur Anwendung kommen.

Eine beispielhafte elektronenleitende Schicht (HBL) kann beispielsweise die folgenden Materialien umfassen z.B. mit ≥ 30 Gew.%, ≥ 50 Gew.%, oder ≥ 70 Gew.%, bezogen auf die elektronenleitende Schicht; im Wesentlichen aus diesen bestehen (z.B. ≥ 90 Gew.%, ≥ 95 Gew.%, oder ≥ 99 Gew.%, bezogen auf die elektronenleitende Schicht); oder sogar aus diesen bestehen (wobei die folgende Liste nicht abschließend ist und zudem Mischungen und isomere Mischungen der genannten Materialien umfasst, beispielsweise auch binäre, ternäre, quaternäre Mischungen, etc.):
Fulleren-Derivate wie C60 PCBM ([6,6]-Phenyl C61 Butansäuremethylester), C70 PCBM ([6,6]-Phenyl C71 Butansäuremethylester), Bis-C60 PCBM (Bis-[6,6]-phenyl C61 Butansäuremethylester), C60 oQDM (o-Chinodimethan C60 Monoaddukt), Bis C60-OQDM (o-Chinodimethan C60 Bisaddukt), ICMA (Inden C60 Monoaddukt, ICBA (Inden C60 Bisaddukt), Fullerol (C60(OH)44); weitere Akzeptoren, umfassend polymere und kleine Moleküle, wie: Dithienoindacen-basierte Verbindungen wie 3,9-bis(2-methylen-(3-(1,1-dicyanomethylen)-indanon))-5,5,11,11-tetrakis(4-hexylphenyl)-dithieno[2,3-d:2',3'-d']-s-indaceno[1,2-b:5,6-b']dithiophen) (ITIC), IT-M (ITIC-M; 3,9-Bis(2-methylen-((3-(1,1-dicyanomethylen)-6/7-methyl)-indanon))-5,5,11,11-tetrakis(4-hexylphenyl)-dithieno[2,3-d:2',3'-d']-s-indaceno[1,2-b:5,6-b']dithiophen), IT-DM (ITIC-DM; 3,9-Bis(2-methylen-((3-(1,1-dicyanomethylen)-6,7-dimethyl)-indanon))-5,5,11,11-tetrakis(4-hexylphenyl)-dithieno[2,3-d:2',3'-d']-s-indaceno[1,2-b:5,6-b']dithiophen) und IDTBR ((5Z,5'Z)-5,5'-((7,7'-(4,4,9,9-Tetraoctyl-4,9-dihydro-s-indaceno[1,2-b:5,6-b']dithiophen-2,7-diyl)bis(benzo[c][1,2,5]thiadiazol-7,4-diyl))bis(methanylyliden))bis(3-ethylthiazolidin-2,4-dion)); Perylendiimid-basierte Verbindungen wie TPB (tert-Butylprydin, C₉H₁₃N), SdiPDI-Se (Perylendiimid-Derivat modifiziert durch die Insertion von Selenophen-Einheiten in die Buchtposition (bay position)), NIDCS-HO ((2E,2'E)-3,3'-(2,5-Bis(hexyloxy)-1,4-phenylen)bis(2-(5-(4-(N-(2-ethylhexyl)-1,8-naphthalimid)yl)-thiophen-2-yl)acrylonitril)); Diketopyrrolopyrrol-basierte Verbindungen wie DPP6 (Dipeptidylaminopeptidase-like protein 6), 6,6'-(Benzo[c][1,2,5]thiadiazole-4,7-diylbis([2,2'-bithiophen]-5',5-diyl))bis(2,5-bis(2- ethylhexyl)-3-(thiophen-2-yl)-2,5-dihydropyrrolo[3,4-c]pyrrol-1,4-dion) (DTDfBT(DPP)2), 6,6',6",6'''-(9,9'-Spirobi[fluoren]-2,2',7,7'-tetrayltetrakis(thiophen-5,2- diyl))tetrakis(2,5-bis(2-ethylhexyl)-3-(5-phenylthiophen-2-yl)-2,5-dihydropyrrolo[3,4- c]pyrrol-1,4-dion) (SF(DPPB)4); PFN (Poly[(9,9-bis(3'-(N,N-dimethylamino)-propyl)-2,7-fluoren)-alt-2,7-(9,9-dioctylfluoren)]), PFN-OX (Poly[9,9-bis(60-(N,N-diethylamino)propyl)-fluoren-alt-9,9-bis-(3-ethyl(oxetan-3-ethyloxy)-hexyl)-fluoren]), PFO (Poly(9,9-di-n-octylfluorenyl-2,7-diyl)), PPDIDTT (Poly{[N,N'-bis(2-decyl-tetradecyl)-3,4,9,10-perylendiimid-1,7-diyl]-alt-(dithieno[3,2-b:2',3'-d]thiophen-2,6-diyl)}), TPBi (1,3,5-Tris(N-phenylbenzimidazol-2-yl)benzol); Metalloxide wie Ti-Oₓ, SnOₓ, etc.

Eine beispielhafte lochleitende Schicht (EBL) kann beispielsweise die folgenden Materialien umfassen z.B. mit ≥ 30 Gew.%, ≥ 50 Gew.%, oder ≥ 70 Gew.%, bezogen auf die elektronenleitende Schicht; im Wesentlichen aus diesen bestehen (z.B. ≥ 90 Gew.%, ≥ 95 Gew.%, oder ≥ 99 Gew.%, bezogen auf die elektronenleitende Schicht); oder sogar aus diesen bestehen (wobei die folgende Liste nicht abschließend ist und zudem Mischungen Mischungen der genannten Materialien umfasst, beispielsweise auch binäre, ternäre, quaternäre Mischungen, etc.): Poly(3-hexylthiophen-2,5-diyl) (P3HT), Poly[2-methoxy-5-(2-ethylhexyloxy)-1,4-phenylenvinylen] (MEH-PPV), Poly[2-methoxy-5-(3',7'-dimethyloctyloxy)-1,4-phenylenevinylene] (MDMO-PPV), CN-PPV, CN-MEH-PPV, andere Phthalocyanine, Poly[(9,9-di-n-octylfluorenyl-2,7-diyl)-alt-(benzo[2,1,3]thiadiazol-4,8-diyl)] (F8BT), Polyfluoren (PF), Poly[2,1,3-benzothiadiazol-4,7-diyl[4,4-bis(2-ethylhexyl)-4H-cyclopenta[2,1-b:3,4-b']dithiophen-2,6-diyl]] (PCPDTBT), Squaraine (z.B. symmetrische Squaraine mit z.B. endständigem Hydrazon mit glykolischer Funktionalisierung oder Diazulen-Squaraine), PTT) (Polythieno[3,4-b]thiophene), poly(5,7-bis(4-decanyl-2-thienyl)-thieno(3,4-b)diathiazole-thiophene-2,5) (PDDTT); Diketopyrrolopyrrol-basierte Polymere wie Poly{2,2'-[(2,5-bis(2-hexyldecyl)-3,6-dioxo-2,3,5,6-tetrahydropyrrolo[3,4-c]pyrrol-1,4-diyl)dithiophen]-5,5'-diyl-alt-thiophen-2,5-diyl} (PDPP3T), Poly[[2,5-bis(2-hexyldecyl-2,3,5,6-tetrahydro-3,6-dioxopyrrolo[3,4 c]pyrrol-1,4-diyl]-alt-[3',3"-dimethyl-2,2':5',2"-terthiophen]-5,5"-diyl] (PMDPP3T), Poly{2,2'-[(2,5-bis(2-hexyldecyl)-3,6-dioxo-2,3,5,6-tetrahydropyrrolo[3,4-c]pyrrol-1,4-diyl)dithiophen]-5,5'-diyl-alt-terthiophen-2,5-diyl} (PDPP5T), Poly[2,6-4,8-di(5-ethylhexylthienyl)benzo[1,2-b;3,4-b]dithiophen-alt-5-dibutyloctyl-3,6-bis(5-bromthiophen-2-yl)pyrrolo[3,4-c]pyrrol-1,4-dion] (PBDTT-DPP); Dithienosilol-basierte Polymere wie Poly[(4,4-bis(2-ethylhexyl)dithieno[3,2-b:2',3'-d]silol)-2,6-diyl-alt-(4,7-bis(2-thienyl)-2,1,3-benzothiadiazol)-5,5'-diyl] (PSBTBT), 7,7'-(4,4-bis(2-ethylhexyl)-4H-silol[3,2-b:4,5-b']dithiophen-2,6-diyl)bis(6-fluoro-4-(5'-hexyl-[2,2'-bithiophen]-5-yl)benzo[c][1,2,5]thiadiazol) (p-DTS(FBTTh2)2), Poly[2,7-(9,9-dioctyl-dibenzosilol)-alt-4,7-bis(thiophen-2-yl)benzo-2,1,3-thiadiazol] (PSiFDTBT); Benzodithiophen-basierte Polymere wie Poly[4,8-bis[(2-ethylhexyl)oxy]benzo[1,2-b:4,5-b']dithiophen-2,6-diyl-alt-3-fluoro-2-[(2-ethylhexyl)carbonyl]thieno[3,4-b]thiophen-4,6-diyl] (PTB7), Poly[(2,6-(4,8-bis(5-(2-ethylhexyl)thiophen-2-yl)-benzo[1,2-b:4,5-b']dithiophen))-alt-(5,5-(1',3'-di-2-thienyl-5',7'-bis(2-ethylhexyl)benzo[1',2'-c:4',5'-c']dithiophen-4,8-dion))]) (PBDB-T), Poly{2,6'-4,8-di(5-ethylhexylthienyl)benzo[1,2-b;3,4-b]dithiophen-alt-5-dibutyloctyl-3,6-bis(5-bromothiophen-2-yl)pyrrolo[3,4-c]pyrrol-1,4-dion (PBDTT-DPP), Poly[4,8-bis(5-(2-ethylhexyl)thiophen-2-yl)benzo[1,2-b;4,5-b']dithiophen-2,6-diyl-alt-(4-(2-ethylhexyl)-3-fluorothieno[3,4-b]thiophen-)-2-carboxylat-2-6-diyl)] (PBDTT-FTTE), Poly[(4,8-bis-(2-ethylhexyloxy)-benzo(1,2-b:4,5-b')dithiophen)-2,6-diyl-alt-(4-(2-ethylhexanoyl)-thieno[3,4-b]thiophen-)-2-6-diyl)] (PBDTTT-C-F), PolyBenzoThiadiaZol(Thiophen)-stat-BenzoDiThiophen(Thiophen)-8 (PBTZT-stat-BDTT-8) und andere Polymere und Copolymere und kleine Moleküle mit Absorptionsmaximum zwischen 320-800 nm; Polytriarylamine und Derivate, Poly[[2,5-bis(2-octyldo-decyl)-2,3,5,6-tetrahydro-3,6-dioxopyrrolo[3,4-c]pyrrol-1,4-diyl]-alt2[[2,2'-(2,5-thiophen)bisthieno[3,2-b]thiophen]-5,5'-diyl]] (DPP(P)), Polyanilin (PANI), Poly[(4,8-bis-(2-ethylhexyloxy)-benzo(1,2-b:4,5-b')dithiophen)-2,6-diyl-alt-(4-(2-ethylhexanoyl)-thieno[3,4-b]thiophen)-2-6-diyl)] (PBDTTT-C), Poly[N29-heptadecanyl-2,7-carbazol-alt-3,6-bis-(thiophen-5-yl)-2,5-dioctyl-2,5-dihydropyrrolo[3,4-]pyrrol-1,4-dion] (PCBTDPP), Poly[[9-(1-octylnonyl)-9H-carbazol-2,7-diyl]-2,5-thiophendiyl-2,1,3-benzothiadiazol-4,7-diyl-2,5-thiophendiyl] (PCDTBT), Poly[2,5-bis(2-octyldodecyl)pyrrolo[3,4-c]pyrrol-1,4(2H,5H)-dion-(E)-1,2-di(2,2'-bithiophen-5-yl)ethen] (PDPPDBTE), Perfluoro(4-methyl-3,6-dioxaoct-7-en)sulfonylfluorid (PFI), Poly(4-styrolsulfonat)-graft-polyanilin (PSS-g-PANI), Copolymer aus 2'-Butyloctyl-4,6-dibromo-3-fluorothieno[3,4-b]thiophen-2-carboxylat (TT-BO), Copolymer aus 3',4'-Dichlorobenzyl-4,6-dibromo-3-fluorothieno-[3,4-b]thiophen-2-carboxylat (TT-DCB) und 2,6-Bis(trimethyl-zinn)-4,8-bis(2-ethylhexyloxy)benzo[1,2-b:4,5-b']dithiophen (BDT-EH) (PTB-DCB21); N2,N2,N2',N2',N7,N7,N7,N7'-Octakis(4-methoxyphenyl)-9,9'-spirobi[9H-fluoren]-2,2',7,7'-tetramin (spiro-OMeTAD), Poly[(9,9-dioctylfluorenyl-2,7-diyl)-co-(4,4'-(N-(4-sec-butylphenyl)diphenylamin)] (TFB), N4,N4'-Di(naphthalen-1-yl)-N4,N4'-bis(4-vinylphenyl)biphenyl-4,4'-diamin (VNPB), 1,4-Bis(4-sulfonatobutoxy)benzol und Thiophenanteil (PhNa-1T)); Metalloxide wie NiOₓ,MoOₓ, etc.

Eine elektronenleitende und/oder eine lochleitende Schicht kann beispielsweise zwischen der ersten Elektrodenschicht und der ersten Schicht und zweiten und ggf. weiteren Schichten, zwischen der ersten Schicht und zweiten und ggf. weiteren Schichten und der Schicht umfassend mindestens einen Szintillator, zwischen einer optionalen Schicht umfassend mindestens einen Szintillator und der zweiten Elektrode, und/oder zwischen der ersten Schicht und zweiten und ggf. weiteren Schichten und der zweiten Elektrode, etc., vorgesehen sein.

Gemäß bestimmten Ausführungsformen umfassen ein Detektor des ersten Aspekts oder ein Detektor des zweiten Aspekts weiter ein Substrat, auf welchem sich die erste Elektrodenschicht befindet, wobei das Substrat bevorzugt einen ersten und einen zweiten Transistor aufweist, wobei weiter bevorzugt der erste Transistor zumindest den ersten Elektrodenpixel und der zweite Transistor zumindest den zweiten Elektrodenpixel der ersten Elektrodenschicht kontaktiert.

Das Substrat ist nicht besonders beschränkt und kann beispielsweise ein pixeliertes Substrat sein. Insbesondere dient das Substrat zur Kontaktierung der Elektrodenpixel und/oder zur Stabilisierung des Detektors, vereinfacht aber auch dessen Herstellung. Das Substrat kann ein solches sein, welches gewöhnlich in Detektoren, insbesondere Röntgen- und/oder Gammadetektoren, vorkommt.

Auch die Transistoren sind nicht besonders beschränkt und können beispielsweise TFT sein. Es können auch mehrere Transistoren ein Elektrodenpixel kontaktieren.

Gemäß bestimmten Ausführungsformen kann sich auf der zweiten Elektrode noch eine Oberflächenschicht, beispielsweise ein Glas und/oder eine Verkapselung, befinden.

Zusätzlich ist der Einbau von Filtern, beispielsweise auf den einzelnen Elektrodenpixeln, wenn die elektromagnetische Strahlung von unterhalb der Elektrodenpixel kommt, oder zwischen der Schicht bzw. den Schichten und der zweiten Elektrode und/oder auf der zweiten Elektrode gegenüber der Schicht bzw. den Schichten denkbar. Auch kann gemäß bestimmten Ausführungsformen die zweite Elektrode eine Filterfunktion übernehmen, beispielsweise indem sie eine unterschiedliche Dicke über verschiedenen Elektrodenpixeln aufweist. Als Filter eignen sich leitende Filter wie beispielsweise Metalle wie Al, Au, Ag, Sn, Cr, Ti, Pt, Pb, Bi, Cu, Mo, Ta, Ga, und/oder Legierungen davon, und/oder auch nichtleitende Verbindungen wie beispielsweise Keramiken, z.B. als Pulver: Al₂O₃, Bornitrid, ZrO₂, AlN, etc. Das Aufhärten des Spektrums für ein gewisses Pixel erleichtert dabei die spektrale Trennung. Die Filter sind hierbei nicht besonders beschränkt.

Ein erfindungsgemäßer Detektor ist insbesondere flächig ausgestaltet. Flächig bedeutet hier gemäß bestimmten Ausführungsformen eine Kontaktierung der Fläche der ersten Schicht pro Elektrodenpixel, die größer als 60% der Fläche der Elektrodenpixel ist, bevorzugt >80%, weiter bevorzugt >90%, z.B. mehr als 95%, mehr als 99%, oder sogar 100%.

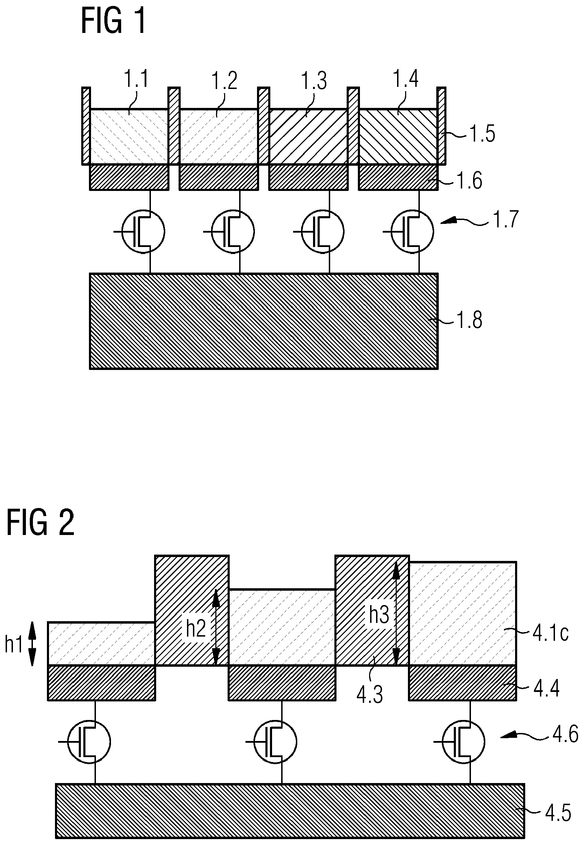

Ein beispielhafter erfindungsgemäßer Detektor des ersten Aspekts ist schematisch in Figur 1 gezeigt, wobei dort eine beispielhafte Schichtanordnung gezeigt ist, hier beispielsweise eines Röntgen- und/oder Gammadetektors (entsprechend den "aktiven Teilen" des Detektors. In Figur 1 ist eine beispielhafte Anordnung für 4 unterschiedliche Perowskite in unterschiedlichen Schichten zu sehen.

Das Substrat 1.8 umfasst Transistoren 1.7, beispielsweise Dünnfilmtransistoren (TFTs) in einem Active Matrix Driving Scheme. Die Transistoren 1.7 kontaktieren die Elektrodenpixel 1.6, die eine strukturierte erste Elektrodenschicht bilden. Zwischen den Elektrodenpixeln 1.6 sind Zwischenräume, über denen sich eine Struktur 1.5 befindet, hier beispielsweise als Gitter bzw. Wände. In der Struktur 1.5 befindet sich eine erste Schicht 1.1 umfassend mindestens einen ersten Perowskiten, welcher rekristallisiert ist, eine zweite Schicht 1.2 umfassend mindestens einen zweiten Perowskiten, welcher rekristallisiert ist, eine dritte Schicht 1.3 umfassend mindestens einen dritten Perowskiten, welcher rekristallisiert ist, und eine vierte Schicht 1.4 umfassend mindestens einen vierten Perowskiten, welcher rekristallisiert ist. Die Perowskite in den nebeneinander liegenden Subpixeln weisen hier unterschiedliche Absorptionseigenschaften auf, wie beispielsweise in Figuren 23 und 24 gezeigt.

Hier teilt die Struktur 1.5, die oberhalb der Elektrodenpixel 1.6 aufgebracht wurde, die verschiedenen Bereiche der Perowskite ab. Die verschiedenen Bereiche können hierbei durch die Transistoren 1.7 ausgelesen und so einzeln verarbeitet werden.

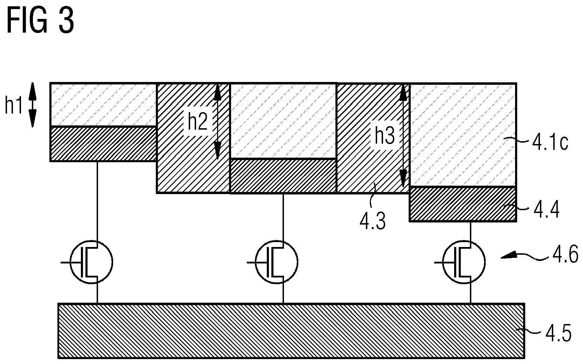

Detektoren des zweiten Aspekts sind in Figuren 2 und 3 gezeigt, wobei hier über dem Substrat 4.5 mit Transistoren 4.6, beispielsweise Dünnfilmtransistoren (TFTs) in einem Active Matrix Driving Scheme, die Elektrodenpixel 4.4 liegen. Zwischen den Elektrodenpixeln 4.4 sind Zwischenräume, über denen sich eine Struktur 4.3 befindet, hier beispielsweise als Gitter bzw. Wände. In der Struktur 4.3 befindet sich eine erste Schicht 4.1c, wobei diese über verschiedenen Elektrodenpixeln 4.4 mit verschiedenen Füllhöhen h1, h2, h3 eingefüllt ist. Es werden also die Füllhöhen h1-h3 der Subpixel variiert bei gleichbleibendem Absorbermaterial. Die Subpixel mit der niedrigsten Füllhöhe h1 ermöglichen nur das vollständige Erfassen von niederenergetischen Photonen. Mit steigender Füllhöhe steigt der absorbierte Anteil von hochenergetischen Photonen. Die Korrelation der Subpixel-Signale ermöglicht eine spektrale Information. In Fig. 2 ist die obere Kante der ersten Schicht auf verschiedenen Ebenen, was zu aufwändiger Kontaktierung der einzelnen Subpixel mit der zweiten Elektrode führen kann. Eine andere Variante, die in Figur 3 gezeigt ist, ist, die Elektrodenpixel 4.4 auf verschiedene Ebenen zu platzieren, sodass die obere Kante der ersten Schicht 4.1c auf einer Ebene liegt.

In beiden Aspekten eines erfindungsgemäßen Detektors wird die spektrale Information von der Korrelation der Elektrodenpixel (Subpixel) gewonnen. Die Helligkeitswerte können mittel gewichteter Kombination der Subpixel-Signale gewonnen werden.

Eine weitere, nicht gezeigte Ausführungsform des Detektors des ersten Aspekts stellt eine Kombination der Figur 1 mit Figur 2 oder 3 dar, wie auch oben beschrieben.

Ergänzend zu dem in Figuren 1 bis 3 exemplarisch gezeigten Schichtaufbauten der Detektoren können sich ein oder mehrere Interlayer, also elektronen- und/oder lochleitende Schichten mit Elektronen- und/oder Loch-leitenden (Loch-/Elektronen blockierenden) Funktionen im Aufbau befinden.

Ein dritter Aspekt der vorliegenden Erfindung betrifft ein Verfahren zur Herstellung eines Detektors für elektromagnetische Strahlung, insbesondere eines Röntgen- und/oder Gammadetektors, umfassend:
- Bereitstellen einer ersten Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel;
- Aufbringen einer Struktur zumindest teilweise auf den Zwischenraum der ersten Elektrodenschicht, wobei die Struktur derart aufgebracht wird, dass die Struktur auf dem Zwischenraum von der ersten Elektrodenschicht weg angeordnet ist, wobei die Struktur einen ersten Bereich über dem ersten Elektrodenpixel von einem zweiten Bereich über dem zweiten Elektrodenpixel trennt;
- Einbringen einer ersten Schicht umfassend mindestens einen ersten Perowskit und einer zweiten Schicht umfassend mindestens einen zweiten, vom ersten Perowskit verschiedenen, Perowskit in die Struktur, wobei die erste Schicht umfassend mindestens einen ersten Perowskit zumindest teilweise in der Struktur derart eingebracht ist, dass sie sich über dem ersten Elektrodenpixel der ersten Elektrodenschicht im ersten Bereich befindet, und wobei die zweite Schicht umfassend mindestens einen zweiten Perowskit zumindest teilweise in der Struktur derart eingebracht wird, dass sie sich über dem zweiten Elektrodenpixel der ersten Elektrodenschicht im zweiten Bereich befindet; und
- Aufbringen einer zweiten Elektrode auf die Struktur und/oder die erste Schicht umfassend mindestens einen ersten Perowskit und/oder die zweite Schicht umfassend mindestens einen zweiten Perowskit; oder
- Bereitstellen einer Struktur, wobei die Struktur mindestens einen Zwischenraum aufweist;
- Einbringen eines ersten Elektrodenpixels und eines zweiten Elektrodenpixels auf verschiedenen Seiten des Zwischenraums der Struktur, wobei der erste Elektrodenpixel und der zweite Elektrodenpixel die Struktur nicht füllen, und dadurch bilden einer ersten Elektrodenschicht, wobei die Struktur einen ersten Bereich über dem ersten Elektrodenpixel von einem zweiten Bereich über dem zweiten Elektrodenpixel trennt;
- Einbringen einer ersten Schicht umfassend mindestens einen ersten Perowskit und einer zweiten Schicht umfassend mindestens einen zweiten, vom ersten Perowskit verschiedenen, Perowskit in die Struktur, wobei die erste Schicht umfassend mindestens einen ersten Perowskit zumindest teilweise in der Struktur derart eingebracht ist, dass sie sich über dem ersten Elektrodenpixel der ersten Elektrodenschicht im ersten Bereich befindet, und wobei die zweite Schicht umfassend mindestens einen zweiten Perowskit zumindest teilweise in der Struktur derart eingebracht wird, dass sie sich über dem zweiten Elektrodenpixel der ersten Elektrodenschicht im zweiten Bereich befindet; und
- Aufbringen einer zweiten Elektrode auf die Struktur und/oder die erste Schicht umfassend mindestens einen ersten Perowskit und/oder die zweite Schicht umfassend mindestens einen zweiten Perowskit.

Gemäß bestimmten Ausführungsformen umfasst das Einbringen der ersten Schicht umfassend mindestens einen ersten Perowskit ein zumindest teilweises Rekristallisieren des mindestens einen ersten Perowskits und/oder das Einbringen der zweiten Schicht umfassend mindestens einen zweiten Perowskit ein zumindest teilweises Rekristallisieren des mindestens einen zweiten Perowskits.

Ein vierter Aspekt der vorliegenden Erfindung ist auf ein Verfahren zur Herstellung eines Detektors für elektromagnetische Strahlung, insbesondere eines Röntgen- und/oder Gammadetektors, gerichtet, umfassend:
- Bereitstellen einer ersten Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel;
- Aufbringen einer Struktur zumindest teilweise auf den Zwischenraum der ersten Elektrodenschicht, wobei die Struktur derart aufgebracht wird, dass die Struktur auf dem Zwischenraum von der ersten Elektrodenschicht weg angeordnet ist, wobei die Struktur einen ersten Bereich über dem ersten Elektrodenpixel von einem zweiten Bereich über dem zweiten Elektrodenpixel trennt;
- Einbringen einer ersten Schicht umfassend mindestens einen ersten Perowskit zumindest teilweise in die Struktur derart, dass sie sich über dem ersten Elektrodenpixel der ersten Elektrodenschicht im ersten Bereich und dem zweiten Elektrodenpixel der ersten Elektrodenschicht im zweiten Bereich befindet, wobei
   sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet; und
- Aufbringen einer zweiten Elektrode auf die Struktur und/oder die erste Schicht umfassend mindestens einen ersten Perowskit; oder
- Bereitstellen einer Struktur, wobei die Struktur mindestens einen Zwischenraum aufweist;
- Einbringen eines ersten Elektrodenpixels und eines zweiten Elektrodenpixels auf verschiedenen Seiten des Zwischenraums der Struktur, wobei der erste Elektrodenpixel und der zweite Elektrodenpixel die Struktur nicht füllen, und dadurch bilden einer ersten Elektrodenschicht, wobei die Struktur einen ersten Bereich über dem ersten Elektrodenpixel und einen zweiten Bereich über dem zweiten Elektrodenpixel trennt;
- Einbringen einer ersten Schicht umfassend mindestens einen ersten Perowskit zumindest teilweise in die Struktur derart, dass sie sich über dem ersten Elektrodenpixel der ersten Elektrodenschicht im ersten Bereich und dem zweiten Elektrodenpixel der ersten Elektrodenschicht im zweiten Bereich befindet, wobei
   sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet; und
- Aufbringen einer zweiten Elektrode auf die Struktur und/oder die erste Schicht umfassend mindestens einen ersten Perowskit.

Gemäß bestimmten Ausführungsformen umfasst das Einbringen der ersten Schicht umfassend mindestens einen ersten Perowskit ein zumindest teilweises Rekristallisieren des mindestens einen ersten Perowskits.

Gemäß bestimmten Ausführungsformen werden die Schritte inn den erfindungsgemäßen Verfahren in der angegebenen Reihenfolge durchgeführt.

Mit den erfindungsgemäßen Verfahren können insbesondere erfindungsgemäße Detektoren hergestellt werden, also mit dem Verfahren des dritten Aspekts Detektoren des ersten Aspekts, und mit dem Verfahren des vierten Aspekts Detektoren des zweiten Aspekts. Entsprechend beziehen sich Beschreibungen zu erfindungsgemäßen Detektoren gemäß bestimmten Ausführungsformen auch auf die entsprechenden erfindungsgemäßen Verfahren sowie vice versa. Insbesondere können die verschiedenen Schichten und Materialien zu deren Herstellung in erfindungsgemäßen Verfahren dieselben sein, welche bereits im Zusammenhang mit den erfindungsgemäßen Detektoren beschrieben wurden, sowie auch umgekehrt. Vorteilhaft ist an den erfindungsgemäßen Verfahren, dass sie leicht auf große Flächen (z.B. 43 x 43 cm²) skalierbar sind.

Erfindungsgemäße Verfahren des dritten und des vierten Aspekts können zunächst die Schritte:
I) - Bereitstellen einer ersten Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel;
   - Aufbringen einer Struktur zumindest teilweise auf den Zwischenraum der ersten Elektrodenschicht, wobei die Struktur derart aufgebracht wird, dass die Struktur auf dem Zwischenraum von der ersten Elektrodenschicht weg angeordnet ist, wobei die Struktur einen ersten Bereich über dem ersten Elektrodenpixel von einem zweiten Bereich über dem zweiten Elektrodenpixel trennt;
      oder die Schritte
II) - Bereitstellen einer Struktur, wobei die Struktur mindestens einen Zwischenraum aufweist;
   - Einbringen eines ersten Elektrodenpixels und eines zweiten Elektrodenpixels auf verschiedenen Seiten des Zwischenraums der Struktur, wobei der erste Elektrodenpixel und der zweite Elektrodenpixel die Struktur nicht füllen, und dadurch bilden einer ersten Elektrodenschicht, wobei die Struktur einen ersten Bereich über dem ersten Elektrodenpixel und einen zweiten Bereich über dem zweiten Elektrodenpixel trennt;
      umfassen.

Unterschieden können die Verfahren beispielsweise hinsichtlich der Herstellung der Struktur. Variante I) ist beispielsweise vorteilhaft bei Verfahren, bei denen die Struktur nachträglich aufgebracht wird, wie beispielsweise bei Lacken, insbesondere Photolacken, oder bei einem 3D-Drucken. Die Variante II) bietet sich dagegen bei Verfahren an, bei denen Teile eines Substrats, etc. entfernt werden, um eine Struktur herzustellen, wie beispielsweise bei einem Ätzen oder eine Laserabtragung, wie oben beschrieben.

Weder das Bereitstellen einer ersten Elektrodenschicht in Variante I), die wie oben beschrieben beschaffen sein kann, noch das Bereitstellen einer Struktur in Variante II), die ebenfalls wie oben beschrieben beschaffen sein kann, beispielsweise basierend auf einem Substrat, sind besonders beschränkt. Das Aufbringen einer Struktur in Variante I) kann wie oben beschrieben beispielsweise durch Auftragen von Lack, beispielsweise Photolack, ggf. auch mehrmalig, und/oder durch 3D-Drucken, etc. erfolgen. Das Einbringen der Elektrodenpixel in Variante II) kann beispielsweise durch Einbringen des Materials der Elektrodenpixel, wie oben beschrieben, in die Region auf verschiedenen Seiten des Zwischenraums bzw. bei mehr als zwei Elektrodenpixeln zwischen mehreren "Zwischenräumen" der ersten Elektrodenschicht (welche dadurch in diesen Ausführungsformen wie oben definiert werden), beispielsweise auch auf Kontaktierungen eines Substrats, und Verflüssigen und wieder Verfestigen (beispielsweise Schmelzen und wieder Erstarren), Einbringen der festen Elektrodenpixel, Verfestigen aus der Gasphase, Abdampfen aus Lösung, etc., erfolgen und ist nicht besonders beschränkt, und kann auch aus Präkursoren des Elektrodenmaterials erfolgen, beispielsweise bei einem Ausfällen. Im Verfahren des vierten Aspekts können die Elektrodenpixel auf verschiedenen Stufen aufgebracht werden, um beispielsweise zum Aufbau der Figur 3 zu gelangen.

Im Verfahren des dritten Aspekts werden dann die erste Schicht und die zweite Schicht eingebracht, wohingegen im Verfahren des vierten Aspekts die erste Schicht mit verschiedener Füllhöhe eingebracht wird. Auch diese Schritte sind nicht besonders beschränkt. Beispielsweise können das Material für die erste Schicht umfassend mindestens einen ersten Perowskit und das Material für die zweite Schicht umfassend mindestens einen zweiten Perowskit und ggf. weitere Materialien für weitere Schichten umfassend mindestens einen weiteren Perowskit (im Verfahren des dritten Aspekts) bzw. kann das Material für die erste Schicht umfassend mindestens einen ersten Perowskit (im Verfahren des vierten Aspekts), beispielsweise jeweils mindestens ein entsprechendes Perowskitmaterial und/oder dessen Präkursoren, als Pulver in die Struktur eingebracht werden und dort verflüssigt und wieder erstarrt werden. Die eingebrachte Materialkomposition muss also nicht der finalen Komposition der finalen ersten Schicht entsprechen. Bei einem Einbringen von Präkursoren kann nach Herstellung des mindestens einen entsprechenden Perowskiten dieser ebenfalls wieder verflüssigt und erstarrt werden, um ihn zu rekristallisieren. Hierbei kann der mindestens eine entsprechende Perowskit bzw. die entsprechende Schicht gut mit der Struktur verbunden und daran befestigt werden, da durch die Flüssigphase eine gute Benetzung erfolgen kann. Das Verflüssigen ist hierbei nicht besonders beschränkt und kann, wie oben bereits im Zusammenhang mit dem Detektor beschrieben, durch Einwirken von Methalamin-Gas (MA-Gas), Druck und/oder Temperatur erfolgen. Das Erstarren und somit Rekristallisieren kann dann entsprechend wieder durch Wegfall des MA-Gases und/oder eine weitere entsprechende Temperatur- und/oder Druckänderung erfolgen, wobei diese an den mindestens einen entsprechenden Perowskiten angepasst sein können.

Ein entsprechendes Verfahren ist für ein Verfahren des dritten Aspekts schematisch in Figuren 14 bis 18 gezeigt. Auf einem Substrat 3.5 befindet sich, wie in Figur 14 gezeigt, eine erste Elektrodenschicht 3.4 umfassend Elektrodenpixel. Über den Zwischenräumen der ersten Elektrodenschicht 3.4 befindet sich eine Struktur 3.3.

In die Struktur 3.3 wird das Material für die erste Schicht als erstes Pulver 3.1, beispielsweise als Perowskitpulver oder als Präkursormaterialien für Perowskit, eingebracht, wie hier beispielhaft in Figur 14 gezeigt. Das Einbringen erfolgt gezielt über einem Elektrodenpixel mittels einer Maske 3.2, wobei das z.B. Perowskitpulver durch die Maskenöffnungen in klar definierte Bereiche über definierte Elektrodenpixel fällt, wobei die Maske 3.2 nur einen oder mehrere bestimmte Elektrodenpixel zugängig macht. In diese gezielt platzierten Öffnungen kann das Perowskitmaterial und/oder das Präkursormaterial gefüllt werden.

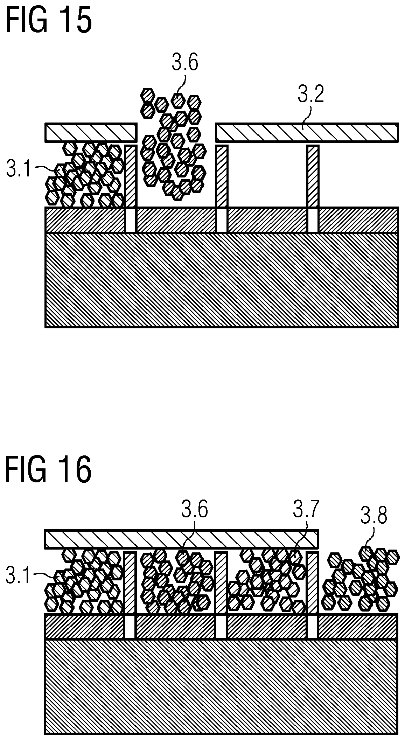

In einen weiteren, in Figur 15 gezeigten Schritt wird nach Justieren bzw. Verschieben der Maske 3.2 in einen anderen abgetrennten Bereich über einen weiteren Elektrodenpixel ein zweites Pulver 3.6 für die zweite Schicht eingebracht, beispielsweise als Perowskitpulver oder als Präkursormaterialien für Perowskit. Im Verfahren des dritten Aspekts unterscheiden sich das erste und zweite Pulver zumindest hinsichtlich des Perowskits oder des Präkursormaterials. In einem Verfahren gemäße dem vierten Aspekt könnte stattdessen wiederum das erste Pulver mit verschiedener Füllhöhe eingefüllt werden. Wie in Figur 16 gezeigt werden anschließend noch ein drittes Pulver 3.7 für eine dritte Schicht, beispielsweise als Perowskitpulver oder als Präkursormaterialien für Perowskit, und ein viertes Pulver 3.8 für eine vierte Schicht, beispielsweise als Perowskitpulver oder als Präkursormaterialien für Perowskit, eingebracht.

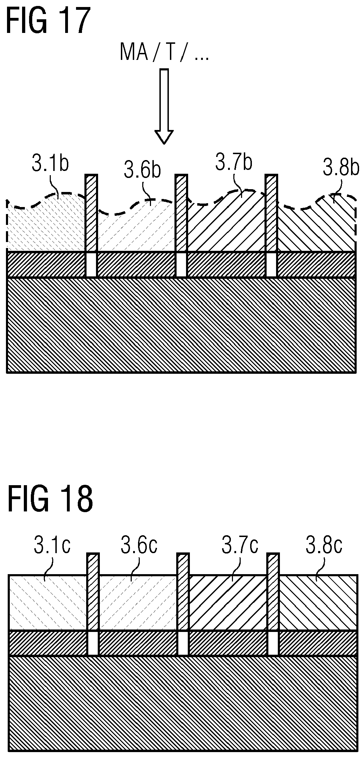

Im in Figur 17 gezeigten Schritt werden anschließend die Pulver durch Einwirkung von MA-Gas, Temperatur T, etc. verflüssigt, sodass sich eine flüssige erste Schicht 3.1b, eine flüssige zweite Schicht 3.6b, eine flüssige dritte Schicht 3.7b und eine flüssige vierte Schicht 3.8b bilden.

Diese werden dann im in Figur 18 gezeigten Schritt rekristallisiert, um eine rekristallisierte erste Schicht 3.1c, eine rekristallisierte zweite Schicht 3.6c, eine rekristallisierte dritte Schicht 3.7c und eine rekristallisierte vierte Schicht 3.8c zu bilden. Diese weisen dann eine gute Adhäsion auf der ersten Elektrodenschicht 3.4 mit einer guten elektrischen Kontaktierung der einzelnen Elektrodenpixel auf deren Oberfläche auf, z.B. größer als 60% der Fläche der Elektrodenpixel, bevorzugt >80%, weiter bevorzugt >90%, z.B. mehr als 95%, mehr als 99%, oder sogar 100%, und ermöglichen eine spektrale Auflösung bei der Detektion elektromagnetischer Strahlung, insbesondere Röntgen- und/oder Gammastrahlung.

Der Prozess der Befüllung der durch die Trennstrukturen abgetrennten Bereiche, die anschließende Verflüssigung und Rekristallisierung kann so oft wiederholt werden, bis die gewünschte Füllhöhe und Schichteigenschaft erreicht wird. Hierbei sind auch unterschiedliche Füllhöhen herstellbar.

Im Anschluss an das Aufbringen der ersten und ggf. zweiten und/oder weiteren Schicht wird die zweite Elektrode aufgebracht, wobei dies ebenfalls nicht besonders beschränkt ist.

Gemäß bestimmten Ausführungsformen wird in einem erfindungsgemäßen Verfahren zumindest zwischen der Struktur und der zweiten Elektrode eine Schicht umfassend mindestens einen Szintillator eingebracht. Diese kann wie oben beschrieben beschaffen sein.

Gemäß bestimmten Ausführungsformen wird in einem erfindungsgemäßen Verfahren weiter eine elektronenleitende und/oder eine lochleitende Schicht zwischen der ersten Elektrodenschicht und der zweiten Elektrode eingebracht. Diese kann an geeigneter Stelle während des Verfahrens aufgebracht werden, also auf die erste Elektrodenschicht, die erste und zweite und ggf. weitere Schicht bzw. die erste Schicht mit verschiedenen Füllhöhen, die Schicht umfassend mindestens einen Szintillator, etc., wie oben im Zusammenhang mit dem Detektor dargelegt. Die Materialien der Schichten entsprechen denen, die im Zusammenhang mit dem Detektor bereits genannt wurden.

Gemäß bestimmten Ausführungsformen wird in einem erfindungsgemäßen Verfahren die erste Elektrodenschicht auf ein Substrat aufgebracht. Dieses ist nicht besonders beschränkt und kann wie oben im Zusammenhang mit dem Detektor ausgestaltet sein.

Gemäß bestimmten Ausführungsformen weist in einem erfindungsgemäßen Verfahren das Substrat einen ersten und einen zweiten Transistor auf, wobei bevorzugt der erste Elektrodenpixel derart aufgebracht wird, dass der erste Elektrodenpixel mindestens den ersten Transistor kontaktiert, und der zweite Elektrodenpixel derart aufgebracht wird, dass der zweite Elektrodenpixel mindestens den zweiten Transistor kontaktiert.

Ebenfalls offenbart ist die Verwendung einer Struktur zur Trennung von Schichten umfassend verschiedene Perowskite oder Schichten umfassend zumindest einen identischen Perowskit mit verschiedener Dicke zur spektralen Auflösung bei der Detektion elektromagnetischer Strahlung, insbesondere Röntgen- und/oder Gammastrahlung.

Die obigen Ausführungsformen, Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmalen der Erfindung. Insbesondere wird der Fachmann auch Einzelaspekte als Verbesserungen oder Ergänzungen zu der jeweiligen Grundform der vorliegenden Erfindung hinzufügen.

Die Erfindung wird im Anschluss mit Bezug auf verschiedene Beispiele davon weiter im Detail erläutert. Die Erfindung ist jedoch nicht auf diese Beispiele beschränkt.

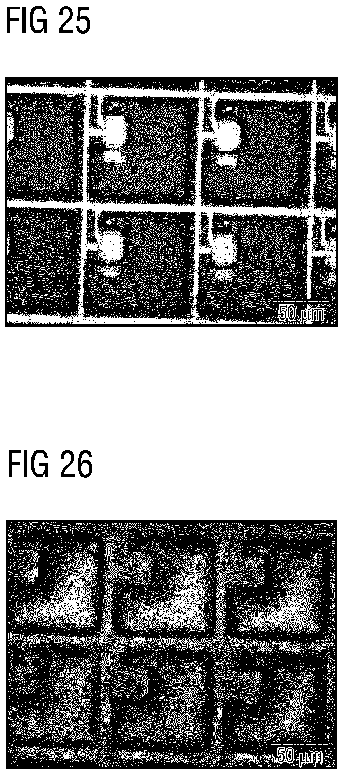

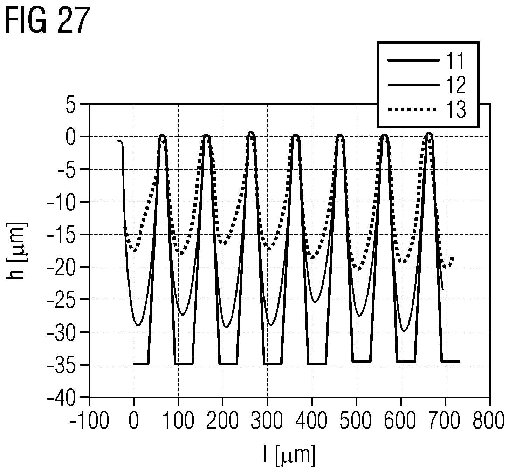

Auf eine erste Elektrodenschicht mit Elektrodenpixeln aus beispielsweise ITO oder Pt wird zwischen den Elektrodenpixeln entsprechend Figur 3 eine Struktur aus SU-8 als Photolack gebildet. In Figur 25 ist hierbei ein beispielhaftes Grid eines pixelierten Substrats ohne Füllung mit Perowskit gezeigt. In die Struktur wird MAPI (CH₃NH₃PbI₃) als Perowskit in Pulverform mit verschiedener Füllhöhe eingebracht, mit MA-Gas verflüssigt und rekristallisiert. In Figur 26 ist das Grid mit Füllung zu sehen, die Pixelelektroden sind gefüllt. Es erfolgt ein mehrmaliges Füllen, um verschiedene Füllhöhen zu erzielen In Figur 27 sind unterschiedliche Füllhöhen als Profil eines Gitters gezeigt, wobei das Gitter ohne Füllung 11, das Gitter nach erster Füllung 12, und das Gitter nach zweiter Füllung 13 gezeigt sind. Im Plot sind die Höhenprofile der Hilfsstrukturen mit einer Höhe von 35 µm nach der Befüllung im 1. Und 2. Beschichtungsschritt zu sehen. Gemäß diesem Beispiel wird die vollständige Füllung der Struktur nach etwa 3-4 Beschichtungsschritten erreicht, wobei dies nicht für jeden Elektrodenpixel durchgeführt wird. Nach Beendigung des Füllens wird auf das MAPI eine zweite Elektrode aus Cr oder Ti aufgebracht.

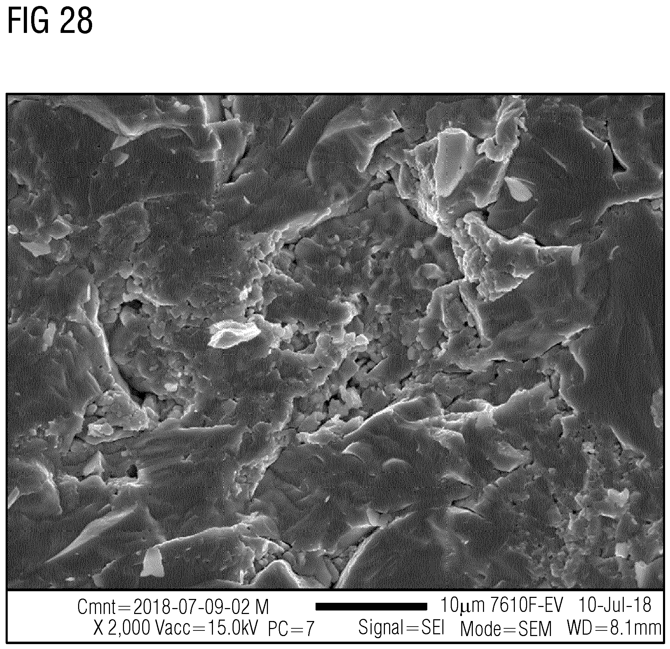

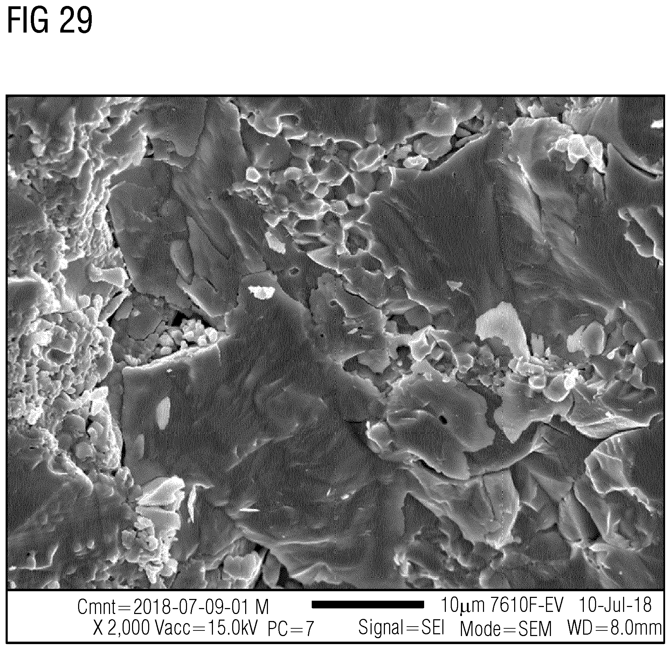

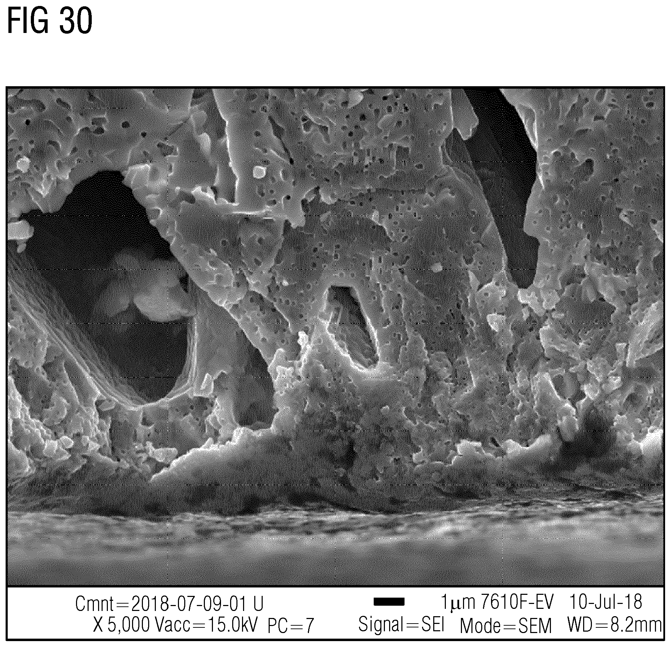

Aus den SEM-Aufnahmen in Figuren 28 bis 30 geht der Einfluss der Rekristallisation durch MA-Gas hervor. Vor der Behandlung, wie in Figur 28 gezeigt, zeigt sich ein homogenes Gefüge mit überwiegend primär Körnern mit rund 5 µm Größe und Agglomeraten derer mit einer Größe von 10-30 µm. Nach der Oberflächenbehandlung ergibt sich, wie in Figur 29 gezeigt, eine "kompakte" Oberfläche, sodass die chemische Reaktion langsam sichtbar ist, aber dennoch kann in der Mitte eine morphologische Änderung beobachtet werden, vor allem durch weniger Agglomerate als in Figur 28. MA-Gas zersetzt also die Kornagglomerate, und mehr kleine Körner (auch Primärkorn genannt) sind sichtbar. An der Kante des Perowskits entstehen, wie in Figur 30 gezeigt, kleine "Austrittkrater", wenn das MA-Gas nach einer gewissen Zeit wieder aus dem Material "ausdampft". Zudem erhöht sich etwas die µ-Porosität.

Mit den vorliegenden Detektoren und Verfahren sind Verschiedene Kombinationen an Materialien und/oder Schichtdicken möglich, wodurch eine Abdeckung eines breiten Spektrums an Photonenergien/Wellenlängen für die Detektion möglich ist. Eine kritische Dicke an Schichten kann durch einen Schicht-zu-Schicht Aufbau einfach erreicht werden. Zudem sind Trennstrukturen einfach mit z.B. Lithographie herstellbar und variabel in der Höhe (je nach Anwendung). Es ergibt sich insbesondere eine einfache Strukturierbarkeit von unterschiedlichen Perowskit-Materialien bzw. verschiedenen Dicken von Detektionsschichten auf Subpixel(Elektrodenpixel) Ebene, insbesondere ohne photolithographische Prozesse, wie auch ein simpler Prozess zur Variierung der Füllhöhe in den Subpixeln, bzw. eine Kombination von verschieden absorbierenden Materialien, die dank einer Maske einfach und schnell nebeneinander aufgetragen werden können. Eine Verwendung von Filtern ist nicht notwendig, aber bei Bedarf auf verschiedenen Elektrodenpixeln möglich bzw. auf unterschiedlichen Elektrodenpixeln (Subpixel) anwendbar. Durch das bevorzugte Verflüssigungs- und Rekristallisationsverfahren gibt es eine gute Kontaktierung mit den Elektrodenpixeln und es wird ein Schicht-zu-Schicht-Prozess möglich, sodass die Schichtdicken anpassbar sind.

## Patentansprüche

1. Detektor für elektromagnetische Strahlung, insbesondere Röntgen- und/oder Gammadetektor, umfassend:
- eine erste Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel,
- eine zweite Elektrode,
- eine erste Schicht umfassend mindestens einen ersten Perowskit, welche sich zwischen dem ersten Elektrodenpixel der ersten Elektrodenschicht und der zweiten Elektrode befindet, und
- eine zweite Schicht umfassend mindestens einen zweiten, vom ersten Perowskit verschiedenen, Perowskit, welche sich zwischen dem zweiten Elektrodenpixel der ersten Elektrodenschicht und der zweiten Elektrode befindet,
weiter umfassend eine Struktur, welche sich zumindest teilweise zwischen der ersten Elektrodenschicht und der zweiten Elektrode befindet und zwischen dem ersten Elektrodenpixel und dem zweiten Elektrodenpixel der ersten Elektrodenschicht derart angeordnet ist, dass sie zumindest teilweise auf dem Zwischenraum zwischen dem ersten Elektrodenpixel und dem zweiten Elektrodenpixel in Richtung der zweiten Elektrode von der ersten Elektrodenschicht weg angeordnet ist, wobei die erste Schicht umfassend mindestens einen ersten Perowskit zumindest teilweise in der Struktur in einem ersten Bereich derart eingebracht ist, dass sie sich über dem ersten Elektrodenpixel der ersten Elektrodenschicht befindet, und wobei die zweite Schicht umfassend mindestens einen zweiten Perowskit zumindest teilweise in der Struktur in einem zweiten Bereich derart eingebracht ist, dass sie sich über dem zweiten Elektrodenpixel der ersten Elektrodenschicht befindet, wobei die Struktur den ersten und zweiten Bereich trennt.

2. Detektor für elektromagnetische Strahlung nach Patentanspruch 1, wobei der mindestens eine erste Perowskit in der ersten Schicht umfassend mindestens einen ersten Perowskit und/oder der mindestens eine zweite Perowskit in der zweiten Schicht zumindest teilweise rekristallisiert ist.

3. Detektor für elektromagnetische Strahlung, insbesondere Röntgen- und/oder Gammadetektor, umfassend:
- eine erste Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel,
- eine zweite Elektrode,
- eine erste Schicht umfassend mindestens einen ersten Perowskit, welche sich zwischen dem ersten Elektrodenpixel der ersten Elektrodenschicht und der zweiten Elektrode befindet und zwischen dem zweiten Elektrodenpixel der ersten Elektrodenschicht und der zweiten Elektrode befindet,
weiter umfassend eine Struktur, welche sich zumindest teilweise zwischen der ersten Elektrodenschicht und der zweiten Elektrode befindet und zwischen dem ersten Elektrodenpixel und dem zweiten Elektrodenpixel der ersten Elektrodenschicht derart angeordnet ist, dass sie zumindest teilweise auf dem Zwischenraum zwischen dem ersten Elektrodenpixel und dem zweiten Elektrodenpixel in Richtung der zweiten Elektrode von der ersten Elektrodenschicht weg angeordnet ist, wobei die erste Schicht umfassend mindestens einen ersten Perowskit zumindest teilweise in der Struktur derart eingebracht ist, dass sie sich über dem ersten Elektrodenpixel der ersten Elektrodenschicht in einem ersten Bereich und dem zweiten Elektrodenpixel der ersten Elektrodenschicht in einem zweiten Bereich befindet, wobei
sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet, wobei die Struktur den ersten und zweiten Bereich trennt.

4. Detektor für elektromagnetische Strahlung nach Patentanspruch 3, wobei der mindestens eine erste Perowskit in der ersten Schicht umfassend mindestens einen ersten Perowskit zumindest teilweise rekristallisiert ist.

5. Detektor für elektromagnetische Strahlung nach einem der vorgehenden Patentansprüche, weiter umfassend eine Schicht umfassend mindestens einen Szintillator, welche sich zumindest zwischen der Struktur und der zweiten Elektrode befindet.

6. Detektor für elektromagnetische Strahlung nach einem der vorgehenden Patentansprüche, weiter umfassend eine elektronenleitende und/oder eine lochleitende Schicht, welche sich zwischen der ersten Elektrodenschicht und der zweiten Elektrode befindet.

7. Detektor für elektromagnetische Strahlung nach einem der vorgehenden Patentansprüche, weiter umfassend ein Substrat, auf welchem sich die erste Elektrodenschicht befindet, wobei das Substrat bevorzugt einen ersten und einen zweiten Transistor aufweist, wobei weiter bevorzugt der erste Transistor zumindest den ersten Elektrodenpixel und der zweite Transistor zumindest den zweiten Elektrodenpixel der ersten Elektrodenschicht kontaktiert.

8. Verfahren zur Herstellung eines Detektors für elektromagnetische Strahlung, insbesondere eines Röntgen- und/oder Gammadetektors, umfassend:
- Bereitstellen einer ersten Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel;
- Aufbringen einer Struktur zumindest teilweise auf den Zwischenraum der ersten Elektrodenschicht, wobei die Struktur derart aufgebracht wird, dass die Struktur auf dem Zwischenraum von der ersten Elektrodenschicht weg angeordnet ist, wobei die Struktur einen ersten Bereich über dem ersten Elektrodenpixel von einem zweiten Bereich über dem zweiten Elektrodenpixel trennt;
- Einbringen einer ersten Schicht umfassend mindestens einen ersten Perowskit und einer zweiten Schicht umfassend mindestens einen zweiten, vom ersten Perowskit verschiedenen, Perowskit in die Struktur, wobei die erste Schicht umfassend mindestens einen ersten Perowskit zumindest teilweise in der Struktur derart eingebracht ist, dass sie sich über dem ersten Elektrodenpixel der ersten Elektrodenschicht im ersten Bereich befindet, und wobei die zweite Schicht umfassend mindestens einen zweiten Perowskit zumindest teilweise in der Struktur derart eingebracht wird, dass sie sich über dem zweiten Elektrodenpixel der ersten Elektrodenschicht im zweiten Bereich befindet; und
- Aufbringen einer zweiten Elektrode auf die Struktur und/oder die erste Schicht umfassend mindestens einen ersten Perowskit und/oder die zweite Schicht umfassend mindestens einen zweiten Perowskit; oder
- Bereitstellen einer Struktur, wobei die Struktur mindestens einen Zwischenraum aufweist;
- Einbringen eines ersten Elektrodenpixels und eines zweiten Elektrodenpixels auf verschiedenen Seiten des Zwischenraums der Struktur, wobei der erste Elektrodenpixel und der zweite Elektrodenpixel die Struktur nicht füllen, und dadurch bilden einer ersten Elektrodenschicht, wobei die Struktur einen ersten Bereich über dem ersten Elektrodenpixel und einen zweiten Bereich über dem zweiten Elektrodenpixel trennt;
- Einbringen einer ersten Schicht umfassend mindestens einen ersten Perowskit und einer zweiten Schicht umfassend mindestens einen zweiten, vom ersten Perowskit verschiedenen, Perowskit in die Struktur, wobei die erste Schicht umfassend mindestens einen ersten Perowskit zumindest teilweise in der Struktur derart eingebracht ist, dass sie sich über dem ersten Elektrodenpixel der ersten Elektrodenschicht im ersten Bereich befindet, und wobei die zweite Schicht umfassend mindestens einen zweiten Perowskit zumindest teilweise in der Struktur derart eingebracht wird, dass sie sich über dem zweiten Elektrodenpixel der ersten Elektrodenschicht im zweiten Bereich befindet; und
- Aufbringen einer zweiten Elektrode auf die Struktur und/oder die erste Schicht umfassend mindestens einen ersten Perowskit und/oder die zweite Schicht umfassend mindestens einen zweiten Perowskit.

9. Verfahren nach Patentanspruch 8, wobei das Einbringen der ersten Schicht umfassend mindestens einen ersten Perowskit ein zumindest teilweises Rekristallisieren des mindestens einen ersten Perowskits und/oder das Einbringen der zweiten Schicht umfassend mindestens einen zweiten Perowskit ein zumindest teilweises Rekristallisieren des mindestens einen zweiten Perowskits umfasst.

10. Verfahren zur Herstellung eines Detektors für elektromagnetische Strahlung, insbesondere eines Röntgen- und/oder Gammadetektors, umfassend:
- Bereitstellen einer ersten Elektrodenschicht umfassend mindestens einen ersten Elektrodenpixel und einen zweiten Elektrodenpixel sowie einen Zwischenraum zwischen dem ersten Elektrodenpixel und dem zweiten Elektrodenpixel;
- Aufbringen einer Struktur zumindest teilweise auf den Zwischenraum der ersten Elektrodenschicht, wobei die Struktur derart aufgebracht wird, dass die Struktur auf dem Zwischenraum von der ersten Elektrodenschicht weg angeordnet ist, wobei die Struktur einen ersten Bereich über dem ersten Elektrodenpixel von einem zweiten Bereich über dem zweiten Elektrodenpixel trennt;
- Einbringen einer ersten Schicht umfassend mindestens einen ersten Perowskit zumindest teilweise in die Struktur derart, dass sie sich über dem ersten Elektrodenpixel der ersten Elektrodenschicht im ersten Bereich und dem zweiten Elektrodenpixel der ersten Elektrodenschicht im zweiten Bereich befindet, wobei
sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet; und
- Aufbringen einer zweiten Elektrode auf die Struktur und/oder die erste Schicht umfassend mindestens einen ersten Perowskit; oder
- Bereitstellen einer Struktur, wobei die Struktur mindestens einen Zwischenraum aufweist;
- Einbringen eines ersten Elektrodenpixels und eines zweiten Elektrodenpixels auf verschiedenen Seiten des Zwischenraums der Struktur, wobei der erste Elektrodenpixel und der zweite Elektrodenpixel die Struktur nicht füllen, und dadurch bilden einer ersten Elektrodenschicht, wobei die Struktur einen ersten Bereich über dem ersten Elektrodenpixel und einen zweiten Bereich über dem zweiten Elektrodenpixel trennt;
- Einbringen einer ersten Schicht umfassend mindestens einen ersten Perowskit zumindest teilweise in die Struktur derart, dass sie sich über dem ersten Elektrodenpixel der ersten Elektrodenschicht im ersten Bereich und dem zweiten Elektrodenpixel der ersten Elektrodenschicht im zweiten Bereich befindet, wobei
sich eine erste Füllhöhe der ersten Schicht umfassend mindestens einen ersten Perowskit über dem ersten Elektrodenpixel im ersten Bereich von einer zweiten Füllhöhe der ersten Schicht über dem zweiten Elektrodenpixel im zweiten Bereich unterscheidet; und
- Aufbringen einer zweiten Elektrode auf die Struktur und/oder die erste Schicht umfassend mindestens einen ersten Perowskit.

11. Verfahren nach Patentanspruch 10, wobei das Einbringen der ersten Schicht umfassend mindestens einen ersten Perowskit ein zumindest teilweises Rekristallisieren des mindestens einen ersten Perowskits umfasst.

12. Verfahren nach einem der Patentansprüche 8 bis 11, wobei zumindest zwischen der Struktur und der zweiten Elektrode eine Schicht umfassend mindestens einen Szintillator eingebracht wird.

13. Verfahren nach einem der Patentansprüche 8 bis 12, wobei weiter eine elektronenleitende und/oder eine lochleitende Schicht zwischen der ersten Elektrodenschicht und der zweiten Elektrode eingebracht wird.

14. Verfahren nach einem der Patentansprüche 8 bis 13, wobei die erste Elektrodenschicht auf ein Substrat aufgebracht wird.

15. Verfahren nach Patentanspruch 14, wobei das Substrat einen ersten und einen zweiten Transistor aufweist, wobei bevorzugt der erste Elektrodenpixel derart aufgebracht wird, dass der erste Elektrodenpixel mindestens den ersten Transistor kontaktiert, und der zweite Elektrodenpixel derart aufgebracht wird, dass der zweite Elektrodenpixel mindestens den zweiten Transistor kontaktiert.
